# EUROPEAN PATENT SPECIFICATION

(11) **EP 3 215 861 B1**
(45) Date of publication and mention of the grant of the patent: **12.12.2018**
(21) Application number: 15784694.0
(22) Date of filing: 23.10.2015
(51) Int. Cl.: G01B 11/02, G01B 11/24, G01R 31/26, G01R 31/265

(54) **AN ASSEMBLY AND METHOD FOR TESTING OPTICAL DEVICES**
ANORDNUNG UND VERFAHREN ZUR PRÜFUNG OPTISCHER VORRICHTUNGEN
ENSEMBLE ET PROCÉDÉ DE TEST DE DISPOSITIFS OPTIQUES

(30) Priority: 05.11.2014 EP 14191888
(43) Date of publication of application: 13.09.2017
(73) Proprietor: Rasco GmbH, 83059 Kolbermoor (DE); ISMECA Semiconductor Holding SA, 2300 La Chaux-de-Fonds (CH)
(72) Inventor: SCARPELLA, Massimo, CH-2416 Les Brenets (CH); NESTOROVIC, Sasa, Escondido, CA 92026 (US)
(74) Representative: P&TS SA (AG, Ltd.)
(86) International application number: PCT/EP2015/074606
(87) International publication number: WO 2016/071124

(56) References cited:
- US-A1- 2012 249 776
- US-A1- 2013 003 051
- US-B1- 7 812 624

## Description

### Field of the invention

The present invention concerns an assembly comprising, a light integrating sphere which has an inlet, and a plurality of inlet adaptors members for modifying the effective dimensions and/or shape of the inlet, so that a tile carrying optical devices for testing can abut an inlet adaptors member to optically seal the light integrating sphere. There is further provided a corresponding method for testing optical devices using the assembly.

### Description of related art

Optical semiconductor devices, such as LEDs or laser diodes or fluorescent bulbs etc., for high-end applications, have to be tested after manufacturing, both with regard to important optical and electrical parameters. Test procedures and apparatus' for implementing such tests at mass production level are well-known.

For testing high-end devices, the optical testing is carried out in an integrating sphere (Ulbricht sphere), wherein the light emitted by the device is integrated. Although the optical devices are, as in the mass production testing of other semiconductor devices, fed to the test device on a matrix-type test array, the testing is made piece-by-piece. In each device testing step, the respective device is brought to a dedicated test position, i.e. to a small opening in the wall of the integrating sphere, and aligned to emit light into the sphere. When testing a plurality of devices which are arranged on a test array, the test array is sequentially shifted in an xy manner, so that all of the devices are brought to the tiny opening which defines the test position. In well-established test procedures, the electrical testing is carried out likewise piece-by-piece, immediately, in advance of or after the optical testing.

In such established test procedures and corresponding arrangements, the time periods required for the electrical and optical testing and the even more significant handling times for bringing each device to the test positon sum up to at least some minutes, for testing all devices of a test array. Moreover, in such procedures it is impossible to fully shield the device under test from ambient light, so that the measured optical values include an offset.

US2012249776 discloses a light-emitting device inspecting apparatus for inspecting characteristics of a light-emitting device including one or more light-emission cells that emit light, the light-emitting device inspecting apparatus including a probing unit having a table on which the light-emitting device is mounted and probes that supply a current to the light-emitting device; an image obtaining unit for obtaining an image of the light-emitting device; and a determination unit for determining open/short defects of the light-emitting device by detecting light-emission of the one or more light-emission cells from brightness information of the image.

It is an objective of the present invention, to provide for an improved assembly and method for testing optical devices which obviates at least some of the disadvantages faced in existing assemblies and procedures of the prior art.

### Brief summary of the invention

According to the present invention there is provided an assembly for testing optical devices, the assembly comprising, a light integrating sphere; a mask member defining an inlet window for the light integrating sphere; and a plurality of inlet adaptor members, each of which can be selectively cooperated with the mask member so as to modify the amount of the inlet window through which light can pass into the light integrating sphere 5a, and wherein each the plurality of inlet adaptor members comprise openings having different shapes and/or dimensions.

In the most favourable embodiment each of the plurality of inlet adaptor members can selectively removably attached to the mask member so as to modify the amount of the inlet window through which light can pass into the light integrating sphere. The inlet adaptor members preferably overlay the inlet window when attached to the mask member.

In another possible embodiment a curtain, which is impermeable to light, extends from the mask member; each of the inlet adaptor members can be selectively positioned to overlay the inlet window, and abut the curtain, so that the curtain is interposed between the mask member and inlet adaptor, so as to modify the amount of the inlet window through which light can pass into the light integrating sphere 5a.

The assembly may further comprises a plurality of tiles, on each of which a test array composed of devices for testing can be provided, wherein the dimensions of each respective tile are larger than the dimensions of an opening provided in a respective inlet adaptor member, so that each of the plurality of tiles can optically seal the opening in a respective inlet adaptor member when the respective tile is moved to abut said respective inlet adaptor member.

Preferably the the shape of the plurality of tiles match to the shape of the openings provided in the respective plurality of inlet adaptor members.

Preferably the dimensions of each respective tile are larger than the dimensions of an opening provided in the respective inlet adaptor member having an opening of shape matching the shape of that tile, so that each tile can optically seal the opening in the respective inlet adaptor member having an opening of shape matching the shape of that tile when the tile is moved to abut said respective inlet adaptor member.

The mask member may further comprise a conduit and each of the plurality of inlet adaptor members may comprise a second conduit, wherein the second conduit of any one of the inlet adaptor members is in fluid communication with the conduit of the mask member when that inlet adaptor member is selectively removably attached to the mask member, and wherein there is further provided a vacuum generator which can be selectively fluidly connected with the conduit in the mask member.

The assembly may further comprise a carrier having a plunger head on the surface of which a tile having a test array, can be supported, wherein the carrier may further comprise, at least one seal which extends above the surface of the plunger head; and one or more vacuum openings defined in the surface of the plunger head through which a vacuum can flow to suck a tile in a direction towards the surface of the plunger head, and wherein the at least one seal is arranged to surround the one or more vacuum openings; and electrical contact pins which can be selectively extended above the surface of the plunger head to electrically contact devices in the test array.

In the most favorable embodiment the plunger head comprises a main member which has a groove defined therein; biasing means such as spring members are provided in the groove; a platform is supported on biasing means. A tile having a test array can be supported on the surface of the platform. Below the platform there is provided electrical contact pins; in the portion of the platform which is positioned above the electrical contact pins there is provided contact sockets through which the contact pins can selectively extend. The contact pins have a fixed position therefore in order to extend the contact pins through the sockets the platform is moved relative to the contact pins. For example, during use in order to extend the contact pins through the sockets provided in the platform, the platform is moved against the biasing means so that the plate moves towards the fixed contact pins. As the plate moves relative to the contact pins the pins extend through the sockets to above the surface of the platform. In one embodiment in order to move the platform against the biasing means, a vacuum is applied to the tile to pull the tile towards the platform of the plunger head; when vacuum pulls the tile towards the platform, the tile compresses the seal and pushes the platform in a direction towards the contact pins so that the contact pins extend through the sockets to contact the electrical contacts of the devices in the test array. Thus the vacuum pulls both the tile and the platform in a direction towards the contact pins so that the contact pins extend through the sockets to contact the electrical contacts of the devices in the test array. Preferably the seal, undersurface of the tile, and the surface of the platform of the plunger head, together define a chamber; negative air pressure is supplied to the chamber so as to create the vacuum which is applied to the tile to pull the tile towards the platform and move the platform towards the electrical contacts, so as to cause the contact pins to extend through the socket and contact the electrical contacts of each device in the test array.

According to a further aspect of the present invention there is provided a method for handling a group of optical devices which are to undergo optical testing, using the assembly according to claim 1, wherein the group comprises more than one optical device, the method comprising the steps of, identifying the shape and dimension of a tile in which a the group of optical devices to be tested is provided; selecting from the plurality of inlet adaptor members, an inlet adaptor member having an opening which has a shape corresponding to the shape of the tile and dimensions which are smaller than the dimensions of the tile; arranging the selected inlet adaptor member to cooperate with the mask member so as to modify the amount of the inlet window through which light can pass into the light integrating sphere; moving the tile so that the group of optical devices as moved into the opening in the inlet adaptor member so that they are in a test position, and so that the tile abuts the inlet adaptor member and optically seals the opening thereby optically sealing the light integrating sphere.

In one embodiment the step of arranging the selected inlet adaptor member to cooperate with the mask member so as to modify the amount of the inlet window through which light can pass into the light integrating sphere comprises, removably attaching the selected inlet adaptor member so as to modify the amount of the inlet window through which light can pass into the light integrating sphere.

Preferably the selected inlet adaptor member is removably attached to the mask member so that the inlet adaptor member overlays the inlet window.

In another embodiment, a curtain, which is impermeable to light, extends from the mask member, and the step of step of arranging the selected inlet adaptor member to cooperate with the mask member so as to modify the amount of the inlet window through which light can pass into the light integrating sphere comprises, positioning the selected inlet adaptor member to abut a free end of the curtain, so that the curtain is interposed between the mask member and inlet adaptor.

The method may further comprise the step of, selecting a tile from a plurality of tiles having different shapes and dimensions, and providing the group of optical devices to be tested on the selected tile.

The method may comprise the step of applying a vacuum to the tile to hold the tile in abutment with the inlet adaptor member, so that the group of optical devices are maintained in the test position.

The method may comprise the steps of using a carrier to move the tile to abut the inlet adaptor member, wherein the carrier comprises a plunger head on which the tile is supported, and wherein said step of using a carrier to move the tile to abut the inlet adaptor member may comprise the steps of, positioning a tile in which the group of optical devices to be tested on the plunger head of the carrier; moving the carrier such that the plunger head and tile are located beneath the inlet adaptor member and centered with respect to the opening in the inlet adaptor member; extending the plunger head so that the tile abuts the inlet adaptor member and optically seals the opening in the inlet adaptor member.

The method may comprises the steps of, applying a vacuum to the tile which sucks the tile in a first direction towards the plunger head; and simultaneously applying a vacuum to the tile, which sucks the tile in a second, opposite, direction, towards the inlet adaptor member to hold the tile in abutment with the inlet adaptor member; and subsequently removing the vacuum which sucks the tile towards the plunger head so that exclusively the vacuum which sucks the tile in a second, opposite, direction, towards the inlet adaptor member, is applied to the tile to hold the tile in abutment with the inlet adaptor member.

The method may comprise the steps of, applying a vacuum to the tile to hold the tile in abutment with the inlet adaptor member; extending said plurality of electrical contact pins from the plunger head, so that the electrical contact pins mechanically contact the electrical contacts of devices in the group; applying a vacuum to the tile to suck the tile towards the plunger head. In one embodiment the method may comprise the step of extending the contact pins through the sockets provided in the platform of the plunger head to contact the electrical contacts of each device in the test array. Most preferably the method comprises the steps of moving the platform, against a biasing means, relative to the contact pins, so that contact pins extend through sockets provided in the platform of the plunger head. In one embodiment the method comprises applying a vacuum to the tile to pull the tile towards the platform of the plunger head, and to pull the platform against the biasing means, so that the contact pins extend through the sockets in the platform of the plunger head to contact the electrical contacts of the devices in the test array. Preferably when the vacuum pulls the tile towards the platform, the tile compresses the seal on the surface of the platform. Thus the vacuum pulls both the tile and the platform in a direction towards the contact pins so that the contact pins extend through the sockets in the platform of the platform to contact the electrical contacts of the devices in the test array. Preferably the method comprises placing the tile on the surface of the platform to form a chamber defined by the seal, undersurface of the tile, and the surface of the platform of the plunger head; and supplying negative air pressure to the chamber so as to create a vacuum within the chamber which pulls the tile towards the platform and moves the platform towards the electrical contacts, so as to cause the contact pins to extend through the socket and contact the electrical contacts of each device in the test array.

The method may further comprise, providing a carrier which has a plunger head which has a surface on which a tile having a test array can be supported, the carrier further comprising, at least one seal which extends above the surface of the plunger head; and one or more vacuum openings defined in the surface of the plunger head through which a vacuum can flow to suck a tile in a direction towards the surface of the plunger head, and wherein the seal is arranged to surround the one or more vacuum openings; and electrical contact pins which can be selectively extended above the surface of the plunger head to electrically contact devices in the test array. and wherein the method may comprise the steps of, applying a vacuum to the tile to hold the tile in abutment with the inlet adaptor member; moving the plunger head of the carrier so that the seal abuts an undersurface of the tile, thereby forming a chamber defined by the surface of the plunger head, the undersurface of the tile and the seal; extending said plurality of electrical contact pins from the plunger head, so that the electrical contact pins mechanically contact the electrical contacts of devices in the group; providing a vacuum in said chamber so that a vacuum is applied to the undersurface of the tile to suck the tile towards the plunger head, to cause electrical contacts of devices in the group to push against the electrical contact pins of the plunger head. In one embodiment the plunger head comprises a main member which has a groove defined therein; biasing means such as spring members are provided in the groove; a moveable platform is supported on biasing means; the platform is selectively moveable against the biasing for the spring members. A tile having a test array can be supported on the surface of the platform. Below the platform there is provided electrical contact pins; in the portion of the platform which is positioned above the electrical contact pins there is provided contact sockets through which the contact pins can selectively extend. The contact pins have a fixed position. In this embodiment the step of extending said plurality of electrical contact pins from the plunger head, so that the electrical contact pins mechanically contact the electrical contacts of devices in the group, comprise moving the platform, against a biasing means, relative to the contact pins, so that contact pins extend through sockets provided in the platform of the plunger head. In one embodiment the method comprises applying a vacuum to the tile to pull the tile towards the platform of the plunger head, and to pull the platform against the biasing means, so that the contact pins extend through the sockets in the platform of the plunger head to contact the electrical contacts of the devices in the test array. Preferably when the vacuum pulls the tile towards the platform, the tile compresses the seal on the surface of the platform. Thus the vacuum pulls both the tile and the platform in a direction towards the contact pins so that the contact pins extend through the sockets in the platform of the platform to contact the electrical contacts of the devices in the test array. Preferably the method comprises placing the tile on the surface of the platform to form a chamber defined by the seal, undersurface of the tile, and the surface of the platform of the plunger head; and supplying negative air pressure to the chamber so as to create a vacuum within the chamber which pulls the tile towards the platform and moves the platform towards the electrical contacts, so as to cause the contact pins to extend through the socket and contact the electrical contacts of each device in the test array.

In one embodiment the method may further comprise the steps of extending said plurality of electrical contact pins and applying a vacuum to the tile to suck the tile towards the plunger head are carried out simultaneously. In the most favorable embodiment applying the vacuum to the tile to suck the tile towards the plunger head causes the plurality of electrical contact pins to extend; for example the vacuum pulls the tray, which in turn pulls the platform of the plunger head on which the tray is supported, against the biasing means to cause the electrical contact pins to extend through sockets in the platform.

The method may further comprise the steps of, performing electrical testing of all the devices in the group simultaneously to determine simultaneously if each of the devices in the group have a predefined electrical property, and performing optical testing, on only those devices in the group which were determined to have said predefined electrical property, to determine if the devices have a predefined optical property, and wherein said optical testing of said devices is performed consecutively on said devices.

The method may further comprise the step of post processing the measurements obtained during the optical testing according to the position of the respective device relative to the center of the integrating sphere.

The method may further comprise the steps of providing a second tile in which another group of optical devices to be tested is provided, the second tile having a shape and/or dimension different to said tile; selecting from the plurality of inlet adaptor members, an second inlet adaptor member having an opening which has a shape corresponding to the shape of the second tile and dimensions which are smaller than the dimensions of the second tile; removing the inlet adaptor member which is attached to the mask member, and attaching the second inlet adaptor member to the mask; moving the second tile so that the other group of optical devices is moved into the opening in the second inlet adaptor member so that they are in a test position, and so that the second tile abuts the second inlet adaptor member and optically seals the opening thereby optically sealing the light integrating sphere.

### Brief Description of the Drawings

The invention will be better understood with the aid of the description of an embodiment given by way of example and illustrated by the figures, in which:
Fig. 1 shows a schematic view (partly as a block diagram) of an assembly according to an embodiment of the invention;
Fig. 2a is a detailed cross sectional view the integrating sphere unit used in the assembly shown in Fig. 1;
Fig. 2b provides a magnified view of the lower assembly of the integrating sphere unit of Fig 2a;
Fig. 2c provides a cross sectional view of the lower assembly of the integrating sphere unit of Fig 2a;
Fig. 2d is a plan view of an example of an inlet adaptor member which can be used in the assembly according to an embodiment of the present invention;
Fig. 2e is a plan view of another example of an inlet adaptor member which can be used in the assembly according to an embodiment of the present invention;
Fig. 2f is a plan view of another example of an inlet adaptor member which can be used in the assembly according to an embodiment of the present invention;
Fig. 2g is a magnified cross section view of one half of the lower assembly of the integrating sphere unit of Fig 2a;
Fig. 2h is a cross sectional perspective view of a test handler in a position directly below the lower assembly, in a position whereby the plunger head is substantially aligned with the center of the opening in the inlet adaptor member;
Fig. 2i is a perspective view of the lower assembly when it comprises an inlet adaptor member which has a square-with cut corners-shaped opening;
Fig. 3 is a perspective view of a plunger head, together with the test array which is shown elevated from the plunger head;
Fig. 4 shows, in a synoptical illustration providing a partial view of the lower portion of the integrating sphere and plunger head, and includes an illustration of the flow of electrical testing signals from the devices on the test array;
Fig. 5a shows an exemplary configuration for a carrier which can be used in an assembly according to the present invention; Fig. 5b shows a magnified view of a nest of the carrier shown Fig. 5a;
Fig. 6 is a plan view of an example tile on which devices to be tested can be supported;
Fig. 7 is a plan view of an example of an inlet adaptor member suitable for use in an assembly according to an embodiment of the present invention, when the devices to be tested are supported on tile shown in Fig. 6;
Fig. 8 illustrates loading a tile of devices onto a surface of a plunger head of a test handler;
Fig. 9 illustrated the test handler which has been moved so that it is adjacent the inlet window of a light integrating sphere;
Fig. 10 illustrates the tile of light emitting devices in the test position;
Fig. 11 illustrates the test handler after it has been moved so that the contact sockets in the contact unit are aligned with electrical contacts of the light emitting devices in a row of the test array;
Figs. 12a &12b illustrate a test handler after having been moved so that the strips on the surface of the plunger head abut an undersurface of the tile;
Fig. 13a illustrates the tile when a vacuum is applied to its undersurface and electrical contact pins of the contact unit have been moved to protrude from the plurality of contact socket to simultaneously mechanically contact all electrical contacts of the light emitting devices in the group;
Figure 13b is a perspective view of a tile on which devices are supported; and shows part of an undersurface of the tile where the electrical contacts of light emitting devices are exposed;
Fig. 14 illustrates part of the assembly according to a further embodiment of the present invention, in which the nest on a rotary
table is located adjacent to a window of the integrating sphere, a part-cut-away portion of the integrating sphere is provided so as provide an illustration of inside of the sphere;
Fig. 15 provides a magnified view of the nest and window inlet shown in Fig.14.

### Detailed Description of possible embodiments of the Invention

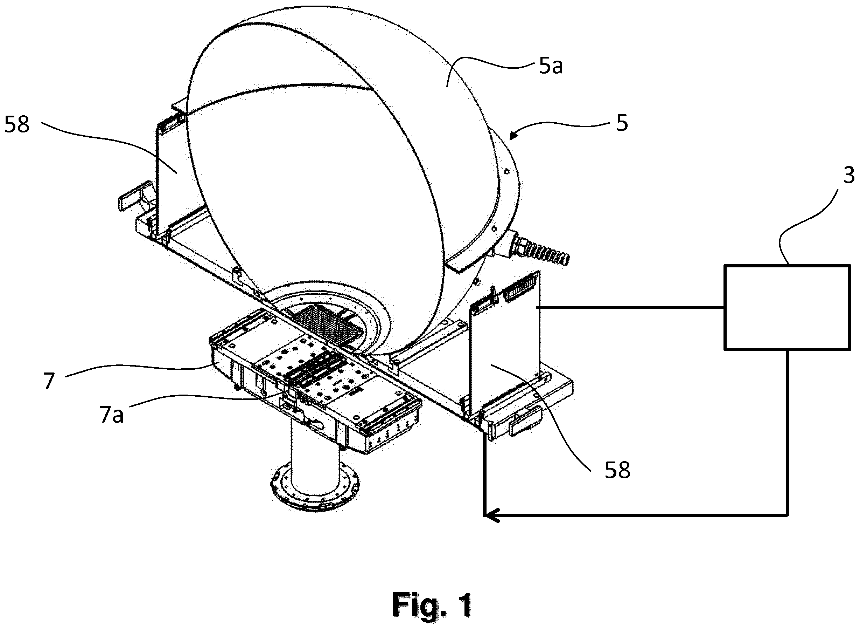

Fig. 1 shows a schematic view (partly as a block diagram) of an assembly 1 (which can be used to test electrical devices; such as light emitting devices for example) according to an embodiment of the invention. The test arrangement 1 comprises a test control and parameter measuring unit 3, an integrating sphere unit 5 and a carrier 7 in the form of a test handler 7 comprising a plunger head 7a. The test control and parameter measuring unit 3 controls a predetermined sequence of electrical and optical test steps for optical devices (i.e. light-emitting devices) (not shown) and provides for measuring the respective electrical and optical parameters. An integrating sphere 5a (shown in cross-section in Figure 1) of the integrating sphere unit 5 accommodates devices in a test position (see further below) and provides an integrating function with respect to the light emission of the devices. The test handler 7 with the plunger head 7a handles the devices is configured to bring devices to the test position and to electrically contact devices to that electrical signals for electrical testing and optical testing can be sent to the devices under test.

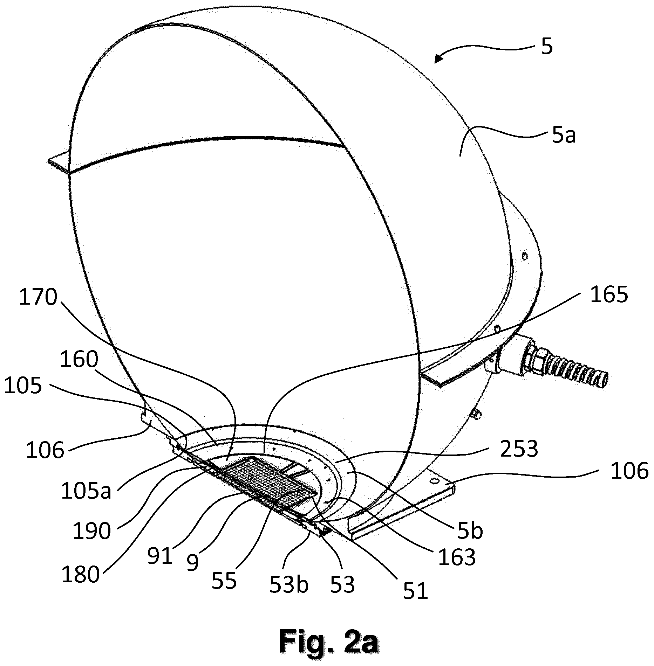

Fig. 2a shows in a detailed cross sectional view the integrating sphere unit 5. The integrating sphere unit 5 comprises an integrating sphere 5a having a circular cut out 105 defined by a rim 105a. The integrating sphere 5a further comprises a flange 106 which extends from the rim 105a. A lower assembly 5b is attached to the integrating sphere 5a and abuts a rim which defines the circular cut out 105.

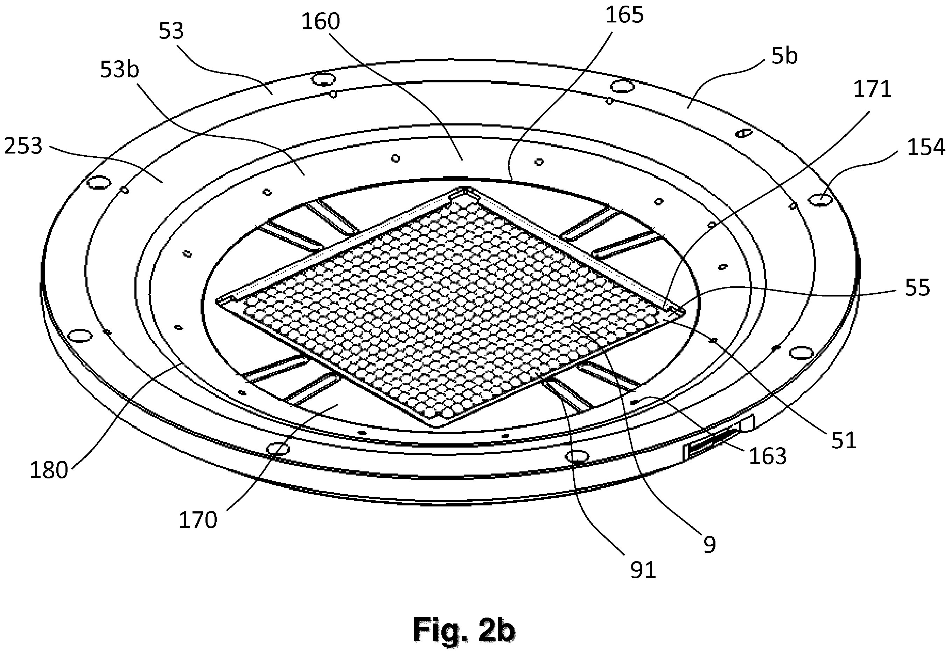

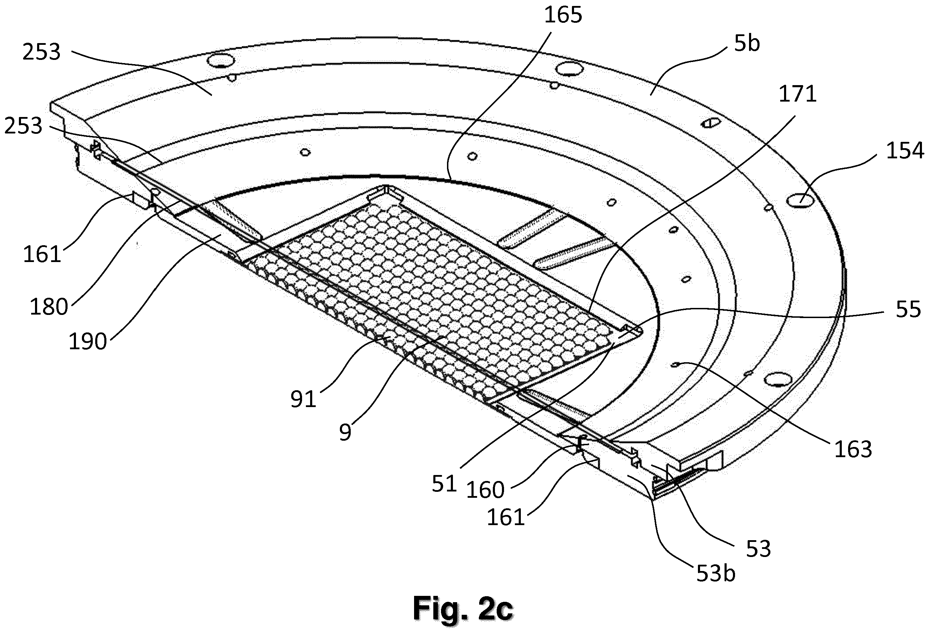

Fig. 2b provides a magnified view of the lower assembly 5b provided in the integrating sphere unit 5 and Fig. 2c provides a cross section of the lower assembly 5b provided in the integrating sphere unit 5. Figs. 2a-c each show a test array 9, comprising a plurality of optical devices 91 to be tested located at a test position, wherein the optical devices 91 can be operated to emit light into the integrating sphere 5a. The test array 9 is located in a tile 55, and the tile 55 will have been brought to the position illustrated by a carrier (not shown) as will be described in more detail later.

Referring to Figs. 2a, 2b and 2c, the lower assembly 5b comprises an annular anchoring member 253. The annular anchoring member 253 comprises through holes 154 through which fasteners, such as screws, can pass to removably attach the anchoring member 253 to the unit 5. In this embodiment the a plate member 5c is interposed between the annular anchoring member 253 and the light integrating sphere 5a; the annular anchoring member 253 is removably attached to a plate member 5c and the light integrating sphere 5a is also attached to the plate member 5c so that it is located opposite to the annular anchoring member 253. The plate member 5c has an aperture allowing light to pass through the plate member 5c and into the light integrating sphere 5a. The annular anchoring member 253 comprises a sealing ring 53; the sealing ring 53 facilitates blocking ambient light from entering into the light integrating sphere 5a. In this embodiment the through holes 154 are defined in the sealing ring 53. In one embodiment the plate member 5c comprises tracks, and the light integrating sphere 5a may comprises corresponding guide members which can be received into the tracks; in this embodiment the integrating sphere 5a may be slid into position on the plate member by moving the integrating sphere 5a so that the guide members are move along the tracks,. The light integrating sphere 5a is held in a fixed position on the plate member 5c by screws provided at the corners of the flange 106.In another embodiment no plate member 5c is provided and the annular anchoring member 253 is removably attached directly to the light integrating sphere 5a.

The lower assembly 5b further comprises a mask member 160. The mask member comprises a sealing ring, referred to hear after as the second sealing ring 53b. The second sealing ring also facilitates blocking ambient from entering into the light integrating sphere 5a.

The mask member 160 comprises a central opening 165, which in this example is square-shaped with cut edges. The central opening defines an inlet window 51 for the light integrating sphere 5a. However, the integrating sphere unit 5 further comprises an inlet adaptor member 170 which modifies the amount of the inlet window 51 available to allow passage of light into the light integrating sphere 5a (i.e. to modify the effective size of the inlet window 51). In this example it can be seen that the inlet adaptor member 170 ensures that a square portion with rounded edges (defined by the opening 171 defined in the inlet adaptor member 170) of the inlet window 51 only is available to allow passage of light into the light integrating sphere 5a; in other words the effective size of the inlet window 51 has been reduced. It will be understood that the opening 171 defined in the inlet adaptor member 170 may be of any suitable shape (e.g. circular, rectangular, square, oval etc.) so that any suitably-shaped-portion of the inlet window 51 is available to allow passage of light into the light integrating sphere 5a; preferably the shape of the opening 171 will correspond to the shape of the tray on which the test array 9 are supported.

The mask member 160 comprises a socket 161 which can receive an inlet adaptor member 170. The inlet adaptor member 170 can be removably attached to the mask member 160 by means of fasteners, such as screws, which are received into holes 163 defined in the mask member 160. In another embodiment a curtain, which is impermeable to light, extends from the mask member 160; and an inlet adaptor member can be positioned to abut a free end of curtain, wherein when an inlet adaptor member is positioned to abut the curtain the curtain is interposed between the mask member and inlet adaptor.

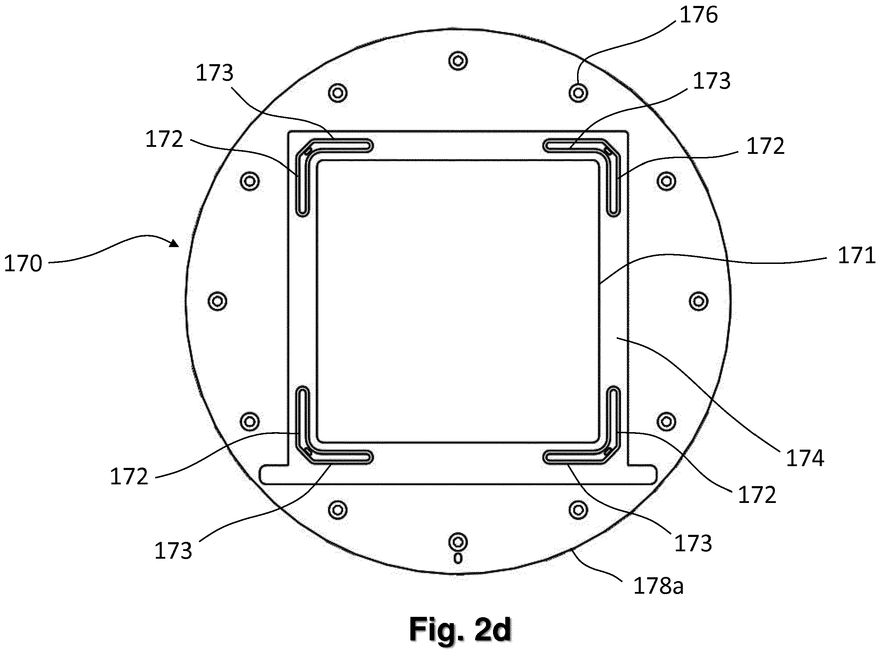

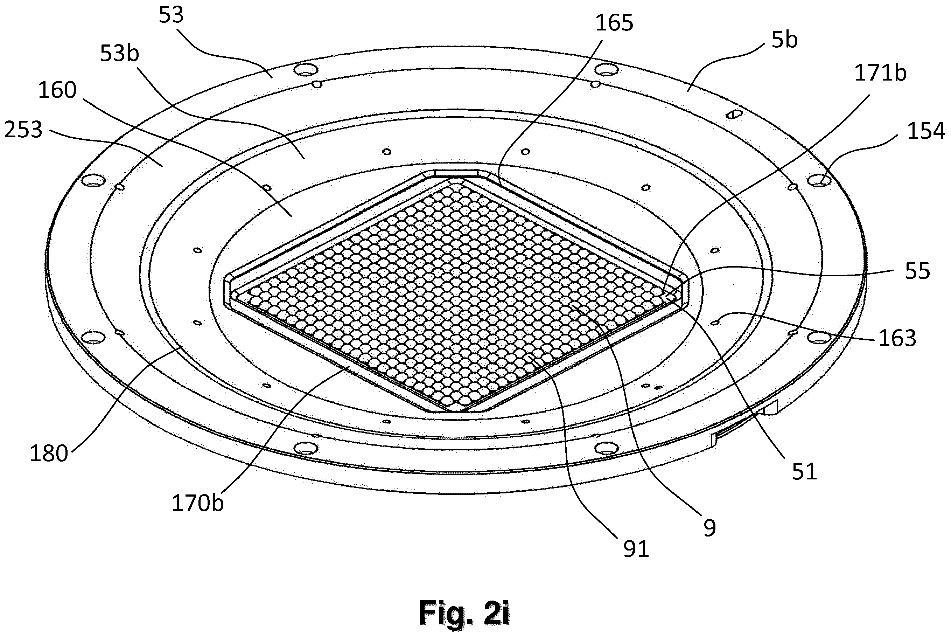

Figure 2d provides a plan view of an inlet adaptor member 170. The inlets adaptor 170 comprises a plurality of holes 176 each of which can receive a fastener, such as a screw, so that the inlet adaptor member 170 can be removeably attached to the mask member 160 when the inlet adaptor 170 is located in the socket 161 of the mask member 160. The inlet adaptor member 170 further comprises flexible members 172 which are located in grooves 173 defined in a surface 174 of the inlet adaptor 170. In this example the flexible members 172 are rubber strips 172, however it will be understood that the flexible members 172 may take any suitable configuration, for example the flexible members 172 extend the whole way around the inlet adaptor so that the flexible members 171 encircle the opening 171. The inlets adaptor 170 comprises an opening 171; in this example the opening 171 is square-shaped; however it will be understood that the opening 171 may be of any suitable shape e.g. a shape customized to any application; for example figure 2i shows a lower assembly 5b which comprises a different inlet adaptor member 170b which comprises a square - with cut corners- shaped opening 171b.

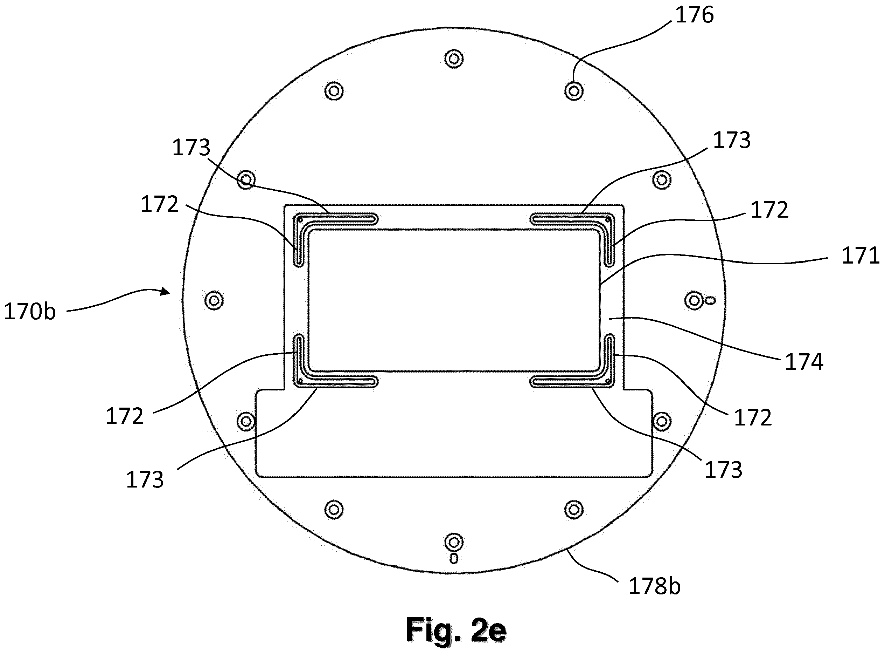

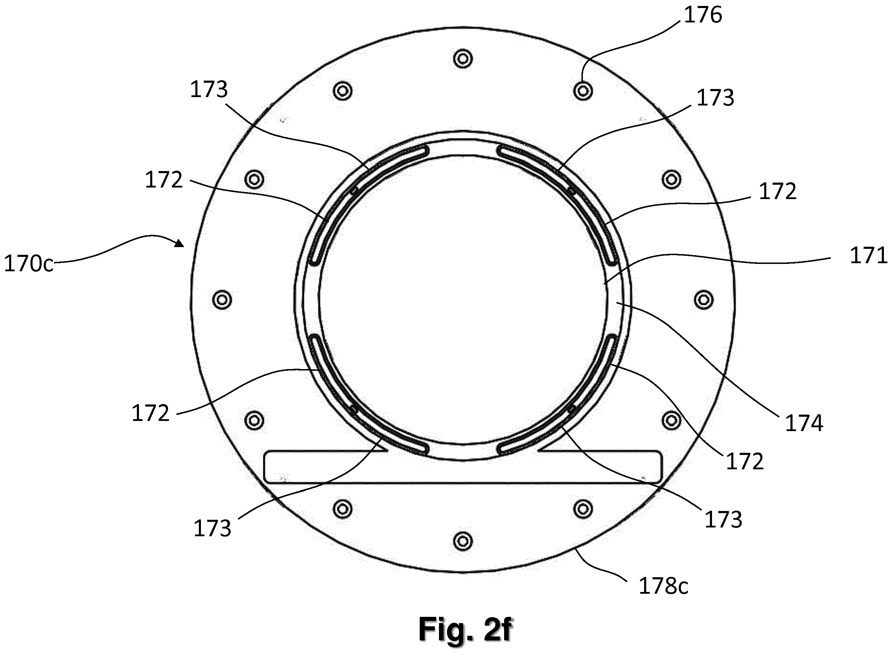

The assembly 1 will comprise a plurality of different inlet adaptor members each having openings of different dimensions and/or shaped and the user selects to attach the inlet adaptor member having an opening with a shape which matches the shape of the tile 55 on when the test array 9 is supported and with dimensions equal to or less than the dimensions of the tile 55 on when the test array 9 is supported and/or which has a shape and/or dimension sufficient to allow the test array 9 that is supported on the tile 55 to be fully contained within the opening. For example, the assembly may comprise the inlet adaptor member 170b which comprises a square - with cut corners- shaped opening 171b, and this may be used with a tray 55 which has dimensions larger than the opening 171b and which supports a test array 9 which can be fully contained within the opening 171b. Figure 2e provides a plan view of another inlet adaptor member 170b; the inlet adaptor member 170b has the same features as the inlet adaptor member 170 shown in Fig. 2d except that the inlet adaptor member 170b comprises an opening 171 which is rectangular shaped with rounded edges. Figure 2f provides a plan view of another inlet adaptor member 170c; the inlet adaptor member 170c has the same features as the inlet adaptor member 170 shown in Fig. 2d except that the inlet adaptor member 170b comprises an opening 171 which is round. The dimensions of the outer perimeters 178a-c of all of the inlet adaptor members 170, 170b, 170c are equal, and are such that any of the inlet adaptor members 170, 170b, 170c can be received into the socket 161 of the mask member 160 to be selectively removably attached to the mask member 160.

When the inlet adaptor member 170 is placed into the socket 161 of the mask member 160 and attached to the mask member 160 a square-shaped portion of the inlet window 51 is available to receive a tile 55 on which the test array 9 is supported, as defined by the inlet adaptor's square-shaped opening 171. Likewise when the inlet adaptor member 170b is placed into the socket 161 of the mask member 160 and attached to the mask member 160 a rectangular-shaped portion of the inlet window 51 is available to receive a tile 55 on which the test array 9 is supported, as defined by the inlet adaptor's rectangular-shaped opening 171. Likewise when the inlet adaptor member 170c is placed into the socket 161 of the mask member 160 and attached to the mask member 160 a round-shaped portion of the inlet window 51 is available to receive a tile 55 on which the test array 9 is supported, as defined by the inlet adaptor's rectangular-shaped opening 171.

Typically, if the devices of test array 9 are supported on rectangular shaped tile 55, then a user will select to attach the inlet adaptor member 170b to the mask member 160 so that the area of the inlet window 51 which is available to receive a tile 55 corresponds to the shape of the tile 55. If on the other hand the devices of the test array 9 are arranged in a square shaped tile 55, then a user will select to attach the inlet adaptor member 170 to the mask member 160 so that the area of the inlet window 51 which is available to receive a tile 55 corresponds to the shape of the tile 55. Likewise if the devices in the test array 9 are arranged in a round-shaped tile 55 then the user will select to attach the inlet adaptor member 170c to the mask member 160. Thus the user selects to attach the inlet adaptor member which has an opening having a shape corresponding to (preferably equal to) the shape (dimensions of the perimeter) of the tile 55 on which the test array 9 is supported; advantageously this allows the tile 55 to be used to optically seal the light integrating sphere 5a. In the most preferred embodiment the inlet adaptor member which is selected to be attached to the mask member 160 will have an opening 171 which is the same shape as the tile 55 (e.g. a square shaped opening for a square shaped tile 55) and also the dimensions of the opening will be less than the dimensions of the tile 55 (e.g. the length of the opening 171 will be shorter than the length of the tile 55 and the width of the opening 171 will be shorter than the width of the tile 55). As the shape of the tile 55 will correspond to the shape of the opening in the attached inlet adaptor member, and since the dimensions of the tile 55 will be larger than the dimensions of the opening 171, when the tile 55 is moved to abut the inlet adaptor member 170 so that test array 9 is brought to the test position, the tile 55 will optical seal the opening 171 in the inlet adaptor member 170 thus optically sealing the integrating sphere 5a. In another embodiment the tile 55 is moved so that it is adjacent to the inlet adaptor member 170, but does not mechanically abut the inlet adaptor member 170, so that test array 9 is brought to the test position; preferably the tile 55 is moved so that there is a gap between 0.1mm-5mm between the tile 55 and the inlet adaptor member 170. Although in this other embodiment the tile 55 will not completely optical seal the opening 171 in the inlet adaptor member 170, the tile 55 will block more of the light from escaping from the integrating sphere 5a.

Referring back to Figs. 2a-c it can be seen that between the mask member 160 and annular anchoring member 253 there is provided a transparent plate 180; the transparent plate 180 prevents dust from entering the integrating sphere 5a through the circular cut out 105. Furthermore when a tile 55 supporting a test array 9 is moved into the opening the inlet adaptor member to optically seal the integrating sphere 5a the transparent plate 180, inlet adaptor member, tile 55, and mask member 160 will define a chamber 190; the temperature within the chamber 190 can be controlled to provide a predefined temperature desired for testing the devices 91 of the test array 9. The assembly 1 will comprise heating and cooling means which are in thermal communication with the chamber 190 and which are operable to adjust the temperature within the chamber 190. The devices 91 in the test array 9 can thus be tested in an environment which has a predefined temperature.

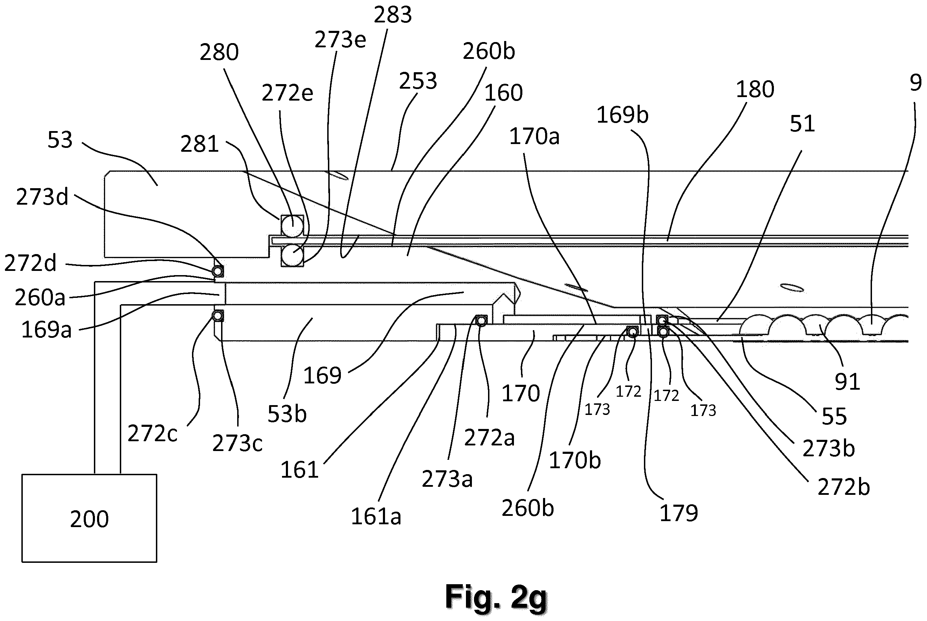

Figure 2g provides a magnified cross section view of one half of the lower assembly 5b shown in figures 2a-c; it will be understood that the other half of the lower assembly 5b will have the same features as shown in Fig. 2g. As shown in Fig. 2g the mask member 160 further comprises a conduit 169 defined therein. An inlet 169a to the conduit 169 is defined in a side surface 260a of the mask member 160. The inlet 169a is shown to be fluidly connected to a vacuum generator 200. An outlet 169b of the conduit 169 is defined in an undersurface 260b of the mask member 160. The outlet 169b is defined in the part of the undersurface 260b which defines the socket 161 such that the conduit 169 is fluidly connected to the socket 161.

The inlet adaptor member 170 also comprises a second conduit 179. The second conduit 179 passes complete through the inlet adaptor member 170, from an upper surface 170a which abuts the mask member 160 to a lower surface 170b against which the tile 55 abuts when the test array 9 is moved to the testing position. The second conduit 179 is defined in the inlet adaptor member 170 at a position in the inlet adaptor member 170 such that it will be fluidly connected to the conduit 169 in the mask member 160 when the inlet adaptor member 170 is received into the socket 161 and attached to the mask member 160 using fastening means. Accordingly, when a tile 55 is moved to bring the testing array 9 to the testing position, the tile 55 will abut the lower surface 170b of the inlet adaptor member 170; in this position the devices 91 of the testing array 9 will extend through the opening 171 of the inlet adaptor member 170 so that they can emit light into the integrating sphere 5a, this position is the testing position; the devices 91 of the testing array 9 can be maintained in this testing position by maintaining the tile 55 in abutment with the lower surface 170b of the inlet adaptor member 170; to achieve this the vacuum generator 200 is operated to generate a vacuum; the vacuum flows through the conduit 169 in the mask member 160, into the second conduit 179 in the inlet adaptor member 170, and is thus applied to the tile to suck the tile 55 towards the lower surface 170b of the inlet adaptor member 170. The vacuum will maintain the tile 55 in abutment with the lower surface 170b of the inlet adaptor member 170 thus maintaining the testing array 9 in this testing position.

As mentioned above the assembly 1 will have a plurality of different inlet adaptor members each having openings of different dimensions; it will be understood that each of the plurality of different inlet adaptor members will have second conduits 179 having the same characteristics as the second conduits 179 described above.

As can also be seen in Fig 2g, the mask member 160 comprises a plurality of flexible members 272a-e each located in a respective groove 273a-e defined on a surface of the mask member 160. In this example the flexible members, 272a-e are each rubber strips 272a-e, however it should be understood that the flexible members, 272a-e may take any other suitable configuration e.g. may enclose the opening 171. The flexible members 272a,b are located in respective grooves 273a,b which are defined in a surface 161a which defines the socket 161; these flexible members 272a,b provide damping for inlet adaptor member 170 when it is moved into the socket 161. The flexible members 272c,d are located in grooves defined in the side surface 260a of the mask member 160 these flexible members 272c,d provide damping for the vacuum generator which may be moved to abut the side surface 260a of the mask member. Finally the flexible member 272e is located in grooves 273e defined in an upper surface 260b of the mask member 160; the flexible member 272e is to provide damping for the transparent plate 180. It is further pointed out that the anchoring member 253 also comprises a flexible member 280 in the form of a rubber strip 280 is located in a groove 281 defined in a lower surface 283 of the anchoring member 253; more specifically the rubber strip 280 is located in a groove 281 defined in the surface 283 of the anchoring member 253 which abuts the located on the surface 283 which abuts the transparent plate 180. Fig. 2g also illustrates rubber strips 172 of the inlet adaptor member 170 provide damping to the tile 55 as the tile is moved to abut the inlet adaptor member 170 so that the test array 9 is in the testing position. As mentioned above the rubber strips 272a-e, 280, 172 all serve to provide damping to devices which abut; the rubber strips 272a-e, 280, 172 also advantageously provide for increase friction so that the devices of are less likely to move with respect to one another. For example the friction between the rubber strips 172 and tile 55 will restrict the tile 55 from moving laterally with respect to the inlet adaptor member 170, thus facilitating maintaining the test array 9 in the test position.

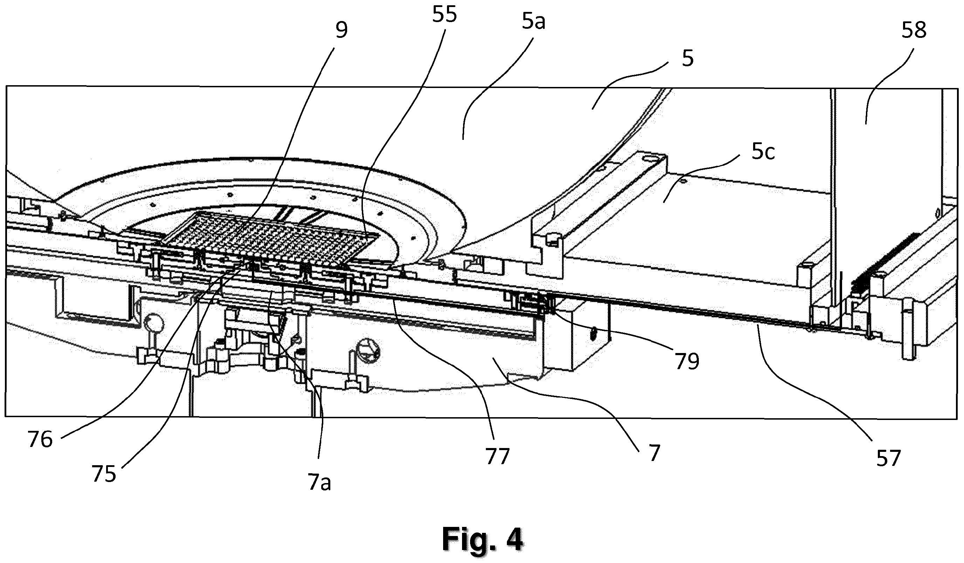

Optionally, the input adaptor member 170 may further comprise a trench 279 defined in a lower surface 170b thereof. During use a tile carrying devices to be tested can be received into the trench 279. The trench 279 will serve to provide some protection for the tile and devices. Preferably the trench 279 is dimensioned so that when a tile is received into trench 279 then electrical contacts of the devices on the tile are located on the same plane at the PCB 57 (shown in Figure 4) of the test arrangement 1; this allows the plunger head 7a to have a flat surface which is easier for manufacturing with less tolerance stack up.

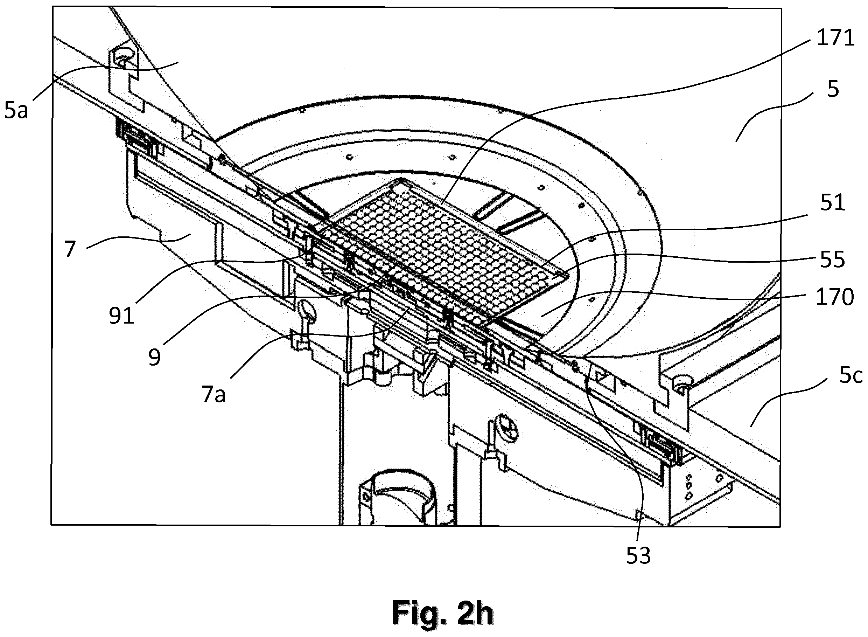

Fig. 2h is a cross sectional perspective view of the test handler 7 in a position directly below the lower assembly 5b in a position whereby the plunger head 7a substantially aligned with the center of the opening 171 in the inlet adaptor member 170. Fig 2h, shows the test array 9, comprising a plurality of optical devices 91 to be tested, located in a tile 55, and the tile 55 is supported on the plunger head 7a of the test handler 7. The tile 55 has been moved by the test handler 7 so that it abuts the inlet adaptor member 170 thereby optically sealing the opening 171 in the inlet adaptor member 170 and ultimately optically sealing the integrating sphere 5a; also when the tile 55 is in this position the testing array 9 is in the testing position and the optical devices 91 of the testing array 9 can be operated they emit light into the integrating sphere 5a. In this example the test array 9 shows a plurality of light emitting devices arranged in a matrix of rows and columns; however it will be understood that the test array may comprise any number of optical devices 91 in any arrangement; for example in an alternative embodiment the test array 9 may comprise a single row of optical devices 91 (e.g. five optical devices arranged in a single row). Also in this example the matrix of optical devices 91 is shown to be supported on a tile 55; however it will be understood that the optical devices 91 could be supported on any other suitable structure such as a strip such as a flexible strip or tape and flexible strip or tape may be configured so that it optically seals the integrating sphere 5a when the tape and/or strip abut the inlet adaptor member 170.

The plunger head 7a is shown in its position immediately below the inlet window 53 and bears tile 55 holding the test array 9 on its surface. It should be understood that, once the test array 9 has been moved by the plunger head 7a into the test position, the tile 55 on which the test array 9 is supported will be released from the plunger head 7a. When the test array 9 has been moved by the plunger head 7a into the test position, a vacuum generated by the vacuum generator 200 will hold the tile 55 so that the test array 9 is maintained in the test position. More specifically, the test handler 7 moves so that its plunger head 7a is substantially aligned with the center of the opening 171 in the inlet adaptor member 170; the plunger head 7, on which the tile 55 holding the test array 9 is then extended from the plunger head 7a so that the tile 55 abuts the inlet adaptor member 170 and optically seals the opening 171; the vacuum generator 200 is then operated to generate a vacuum which passes through the conduit 196 in the mask member 160, through the second conduit 179 in the inlet adaptor member 170 where is it applied to the tile 55 to such the tile 55 towards inlet adaptor member 170 so that the position of the tile 55 is maintained thereby maintaining the test array 9 in the test position.

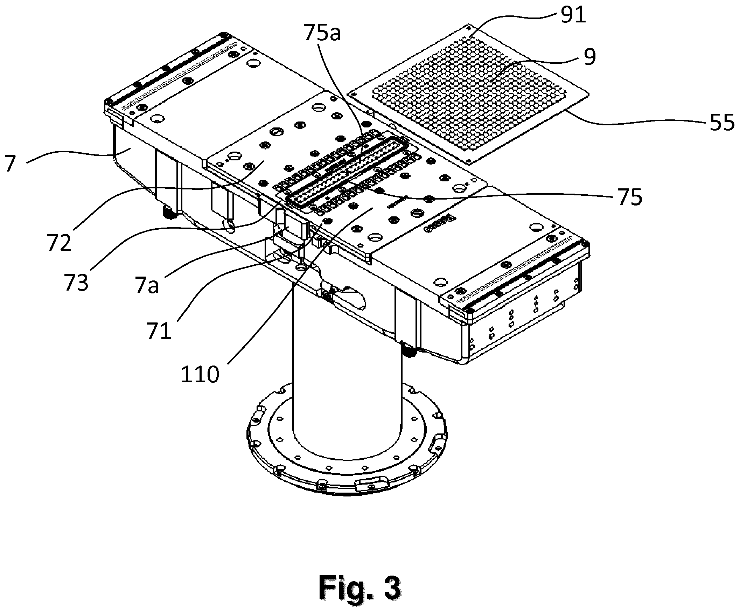

Figure 3 is a perspective view of the test handler 7, together with the test array 9 supported on the tile 55; the test array 9 is illustrates elevated from the plunger head 7a to allow the surface 72 of the plunger head 7a to be seen. It should be noted that the plunger head 7a can extend linearly from the test handler 7 to deliver the test array 9 to a test position in the light integrating sphere 5a. A plurality of vacuum openings 71 are defined in the surface 72 of the plunger head 7a (it will be understood that any number of vacuum openings 71 may be provided, for example a single vacuum opening 71 may be provided; preferably between 10-50 vacuum openings 71 are provided); the vacuum openings 71 are each in fluid communication with a vacuum generating means (not shown) so that a vacuum can be applied to the tile 55 supported on, or abuts, the surface 72. Applying a vacuum to the tile 55 supported on the surface will serve to hold the tile 55 on the surface 72; applying a vacuum to a tile 55 which abuts the surface 72 will facilitate establishing electrical contact between contacts on the test handler 7 and the light emitting devices 91 in the test array 9 as will be described in more detail later.

A contactor unit 75 is further provided in the plunger head 7a. The contact unit comprises a plurality of electrical contact pins (not shown); the electrical contact pins can be selectively protruded through contact sockets 75a which are provided on the surface 72 of the plunger head 7a, so that the electrical contact pins extend from the surface 72 of the plunger head 7a. The electrical contact pins are protruded through the contact sockets 75a to electrically contact the optical devices 91, when the tile 55 is held by the docking means in the integrating sphere unit 5; electrical signals to implement electrical and optical testing is sent via the electrical contact pins to the optical devices 91. In the embodiment shown, a plurality of contact sockets 75a, and correspondingly a plurality of electrical contact pins are provide; this enables a plurality of optical devices 91 of a single row of the test array, to be simultaneously contacted. In this embodiment the plunger head 7a comprises a main member 107 which has a groove 108 defined therein; biasing means 109 which in this example are in the form of spring members 109 are provided in the groove 108; a moveable platform 110 is supported on spring members 109; the platform 110 is selectively moveably against the springs 109. The tile 55 having a test array 9 is supported on the surface 72 of the platform 110 of the plunger head 7a. The electrical contact pins are provided below the platform 110; and the contact sockets 75a are provided in the portion of the platform 110 which is positioned above the electrical contact pins. The electrical contact pins have a fixed position therefore in order to extend the contact pins through the contact sockets 75a the platform 110 is moved relative to the contact pins. For example, during use in order to extend the contact pins through the contact sockets 75a provided in the platform 110, the platform 110 is moved against the biasing force of the springs 109 so that the plate moves towards the fixed contact pins. As the platform 110 moves relative to the contact pins the pins extend through the contact sockets 75a to above the surface 72 of the platform 110. In one embodiment in order to move the platform 110 against the springs 109, a vacuum is applied to the tile 55 to pull the tile 55 towards the platform 110; as the tile 55 is pulled it moves the platform 110 in a direction towards the contact pins so that the contact pins extend through the contact sockets 75a and contact the electrical contacts of the devices 91 in the test array 9. Thus the vacuum pulls both the tile and the platform in a direction towards the contact pins so that the contact pins extend through the contact sockets 75a to contact the electrical contacts of the devices 91 in the test array 9.

Seal(s) 73 are provided on the surface 72. In this example the seals are composed of rubber. In this example the seal(s) 73 are provided on the surface and the seals are arranged to extend along a respective rectangular groove (having rounded edges). Each seal 73 is configured to have dimensions which ensure that it protrudes from its respective groove. Accordingly, the seal(s) 73 each protrude above the surface 72 of the test handler 7. The seal(s) 73 facilitate the application of a vacuum to the tile, as will be described in more detail later, and thus is often referred to as a vacuum seal. For example, preferably the seal, undersurface of the tile 55, and the surface 72 of the platform 110 of the plunger head, together define a chamber when the tile 55 is supported on the plunger head 7a; negative air pressure is supplied to the chamber so as to create the vacuum which is applied to the tile 55 to pull the tile 55 towards the platform 110 and move the platform 110 towards the electrical contacts, so as to cause the contact pins to extend through the contact sockets 75a and contact the electrical contacts of each device 91 in the test array 9.

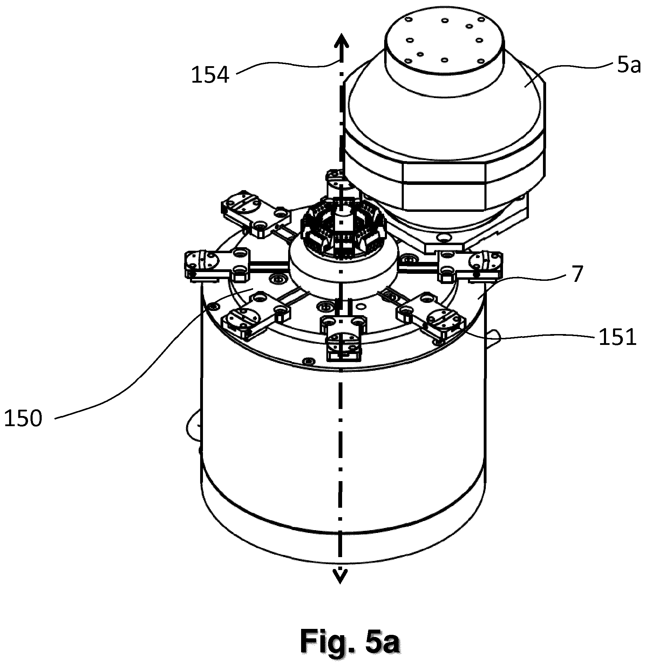

It should be understood that the carrier 7 provided in the assembly of the present invention may take any suitable configuration and is not limited to being in the form of a test handler 7 with plunger head 7a. Figure 5a provides a perspective view of another exemplary configuration for the carrier 7. The carrier 7 shown in Figure 5a comprises a rotary table 150 having a plurality of nests 151. The rotary table 150 is configured so that it can rotate about a rotary axis 154. The rotary table 150 is positioned below the light integrating sphere 5 in the assembly and is arranged such that a nest 151 is directly aligned with the inlet window 51 of the light integrating sphere 5a. The rotary table 150 can be selectively rotated about the rotary axis 154 to move another of the nests 151 so that it directly aligned with the inlet window 51 of the light integrating sphere 5a.

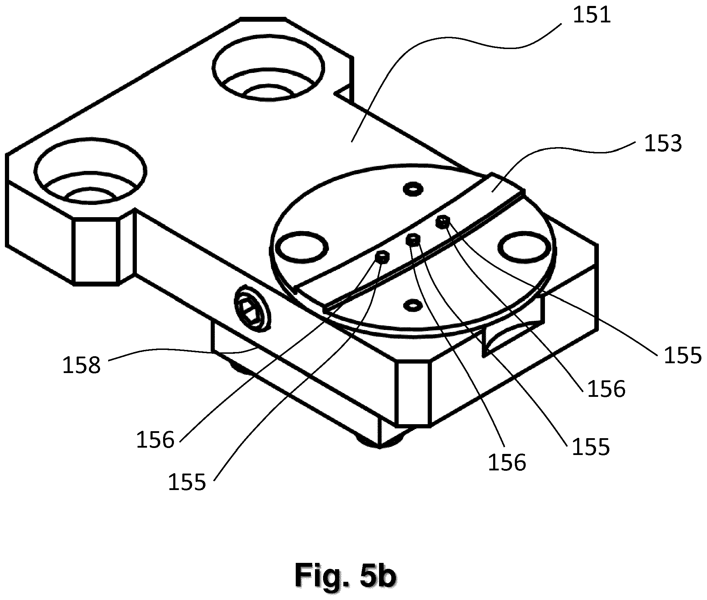

Figure 5b provides a perspective view of a nest 151. The nest 151 comprises a flat surface 153 on which a group of devices can be supported. The nest 151 is configured such that no part of the nest 151 extends above the plane of the flat surface 153. In this embodiment the flat surface 153 on which the devices can be supported defines the top surface or more specifically defines the uppermost surface of the nest 151.This ensures that no part of the nest 153 will obstruct light emitted by the devices which are positioned on the flat surface 153. Also the flat surface allows any sized device to be supported on the nest, so the carrier is not limited to carry devices of specific dimensions. This is in contrast to nests used in the prior art which comprise cavities defined by a base and walls, and wherein the devices are supported on the base of those cavities, and wherein the walls of the cavities extend above the base. Disadvantageously in the nests of the prior art the walls of the cavities will obstruct light emitted by a light emitting device located in the cavity so that some of the light emitted will not be received into the light integrating sphere 5a during testing. In the present invention since the nest is without a structure which extends above the plane of the flat surface on which the device is supported, no part of the nest will obstruct the emission of light from the light emitting device, so that all light emitted will be received into the light integrating sphere 5a during testing.

The nest further comprises designated areas 155 of the flat surface 153 in which light emitting devices can be positioned. Within each of these areas 155 there is provide a vacuum opening 156 (which is covered by the light emitting devices in Figure 5b). Each of the vacuum openings 156 is fluidly connected to a vacuum generating means so that a vacuum can be applied to devices which are positioned in the designated areas 155 of the flat surface 153.

Each of the designated areas 155 comprise electrical contacts (which is covered by the light emitting devices in Figure 5b). The electrical contacts of each of the designated area 155 is electrically connected to a respective light emitting device which is positioned at that area 155.

Electrical contact pins 79 of a contact unit 75 which is electrically connected to a control and parameter measuring unit 3 can be moved to contact the electrical contacts provided in the nest 151; and the electrical signals which implement the electrical and/or optical testing can be sent by the control and parameter measuring unit 3 to the devices supported on the flat surface 153 of the nest.

It will be understood that the nest 151 may have any one or more of the features of the test handler 7 shown in Figures 1-3.

Fig. 4 shows, in a synoptical illustration combining a partial view of Fig. 2 and a signal flow diagram, how in the electrical testing signals from the devices on the test array 9 are routed through the plunger head 7a or electrical contact pins, respectively, and the integrating sphere unit 5. Electrical contact pins (embodied typically as so-called pogo pins) 76 in the contactor unit 75 collect the signals and rout them through leads provided in the contactor unit, including a lead arrangement on a PCB 77, to output contacts 79 of the plunger head. There, the measuring signals are handed-over to the integrating sphere unit 5, more specifically to a contact pin arrangement 55 and a PCB 57 of that device of the test arrangement. Output contacts (not shown) of the PCB 57 are connected to the test control and parameter measuring unit 3 (Fig. 1).

In an embodiment the multiplexer 58 can comprise four input channels which can receive command signals from the control and parameter measuring unit 3; and for each input channel there is provided a group of eight output channels each of which is electrically connected to a series of eight electrical contact pins 79 of the contact unit 75 which can output electrical testing electrical signals which implement electrical tests. In this embodiment each device comprises a pair of electrical contact pins 79, therefore two multiplexers 58 (first and second multiplexers 58) are provided to allow electrical testing of a group of eight devices simultaneous. During electrical testing each respective group of eight output channels of each multiplexer 58 is addressed consecutively, so that electrical signals which implement electrical tests are passed consecutively to groups of eight devices (each device in the group of eight receiving simultaneously the electrical signals). For example in order to perform electrical testing of 24 devices electrical testing is performed on three groups of eight devices (first, second and third group of eight devices); a first group of eight output channels of a first multiplexer are addressed (via the first input channel) to allow electrical testing electrical signals which implement electrical tests to be passed simultaneously to four devices in the first group of eight device (i.e. four pairs of electrical contact pins 79 channels) simultaneously a first group of eight output channels of a second multiplexer are addressed (via the first input channel) to allow electrical testing electrical signals which implement electrical tests to be passed simultaneously to the remaining four devices in the first group of eight device (i.e. four pairs of electrical contact pins 79 channels). To test the second group of eight devices a second group of eight output channels of a first multiplexer are addressed (via the second input channel) to allow electrical testing electrical signals which implement electrical tests to be passed simultaneously to four devices in the second group of eight device (i.e. four pairs of electrical contact pins 79 channels) simultaneously a second group of eight output channels of a second multiplexer are addressed (via the first input channel) to allow electrical testing electrical signals which implement electrical tests to be passed simultaneously to the remaining four devices in that second group (i.e. four pairs of electrical contact pins 79 channels). To test the final eight devices out of the '24' device, a third group of eight output channels of a first multiplexer are addressed (via the second input channel) to allow electrical testing electrical signals which implement electrical tests to be passed simultaneously to four devices in the third group of eight (i.e. four pairs of electrical contact pins 79 channels) simultaneously a second group of eight output channels of a second multiplexer are addressed (via the first input channel) to allow electrical testing electrical signals which implement electrical tests to be passed simultaneously to the remaining four devices in the third group (i.e. four pairs of electrical contact pins 79 channels).Thus all '24' device will have undergone electrical testing. It will be understood that multiplexer 58 may have any suitable configuration e.g. it may have any number of input and output channels; it will also be understood that any number of multiplexers may be provided (i.e. the present invention is not limited to requiring two multiplexers).

According to an exemplary contacting and measuring scheme of a optical device panel, the electrical test starts with contacting all devices on a first row of the panel, e.g. 24 devices. Then, the devices on this first row are electrically tested, sequentially e.g. in three groups each comprising 8 devices. After the electrical test sequence, the arrangement is switched to start the sequential optical tests, driving all devices of the first row individually and measuring the individual optical parameters of the respective device. Once the electrical and optical testing of all devices of the first row is terminated, the arrangement is mechanically indexed, i.e. the row contactor unit shifted by one row distance and the second row contacted. Then the whole procedure is repeated for the second row, and so forth, until all devices in all rows have been tested.

The above-mentioned assembly can be used to perform a method according to the present invention:

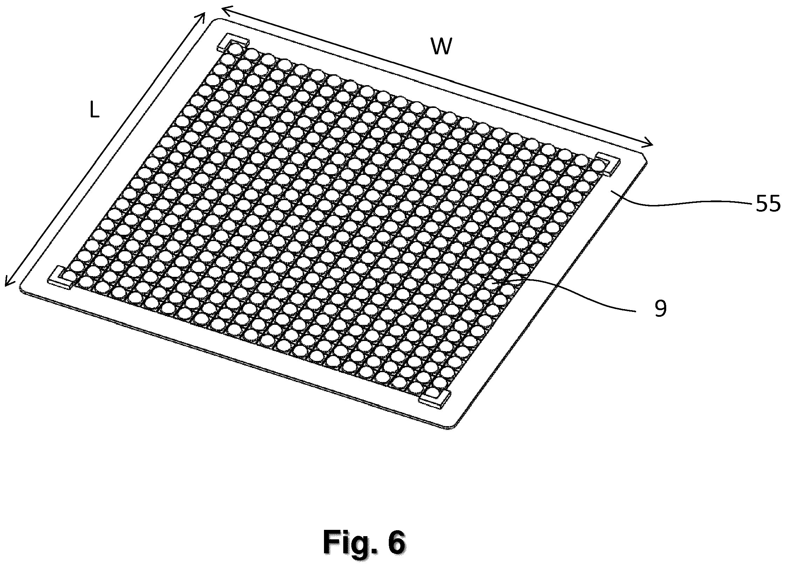

Firstly the shape and dimensions of the tile 55 in which the test array 9 is arranged, are checked. In this example the tile 55 is a square shape, having a length 'L' of 100mm and a width 'w' of 100mm, as shown in Figure 6.

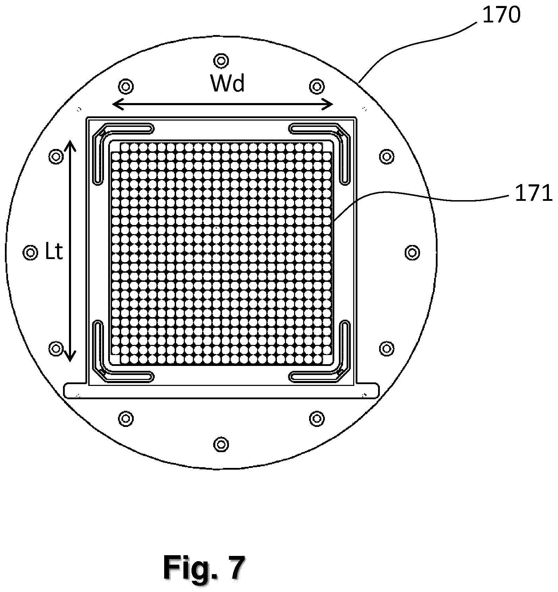

Next the user selects from a plurality of different inlet adaptor members, each having openings of different shapes and/or dimensions (e.g. the inlet adaptor members shown in Figures 2d-f), an inlet adaptor having an opening which has a shape corresponding to the shape of the tile 55 and dimensions less than the dimensions of the tile (i.e. the length and width of the opening being less than the respective length and width of the tile 55). Figure 7 shows a plan view of an example of an inlet adaptor member 170 which could be selected for use with the tile 55 shown in Figure 6; the inlet adaptor member 170 has an opening 171 which is square shape and having a length 'Lt' of 85mm and a width 'wd' of 85mm.

The user then inserts the selected inlet adaptor member 170 into the socket 161 in the mask member 160, and attaches the inlet adaptor member 170 to the mask member 160 using fasteners which are passed through the holes 176 provided in the inlet adaptor member 170.

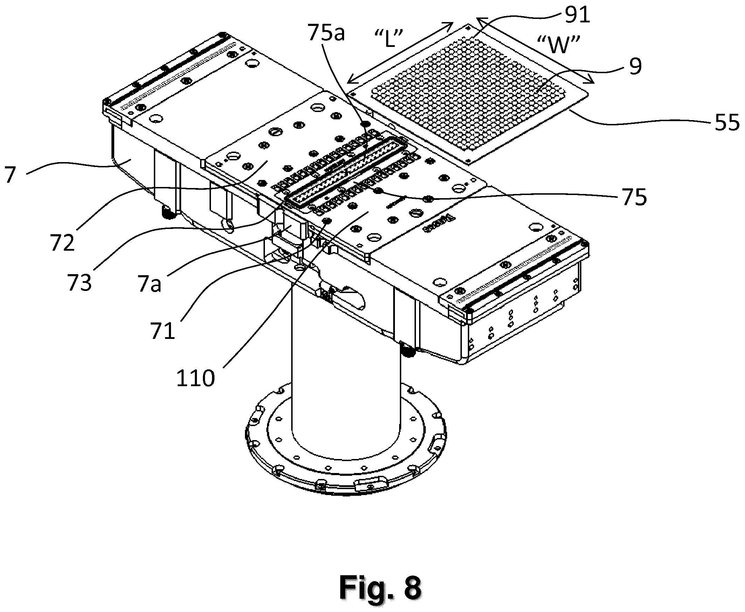

A plurality of optical devices 91 are the provided on a tile 55 to form a test array 9. The tile 55 is then arranged onto the surface 72 of the plunger head 7a of the test handler 7, and is located substantially in the center of the plunger head 7a, as is illustrated in Figure 8.

After the tile 55 has been arranged onto the surface 72, the vacuum generator, which is in fluid communication with the vacuum opening 71, is then operated so that a vacuum is applied to the tile 55 so that the tile 55 (and test array 9) is held on the surface 72 of the plunger head 7a.

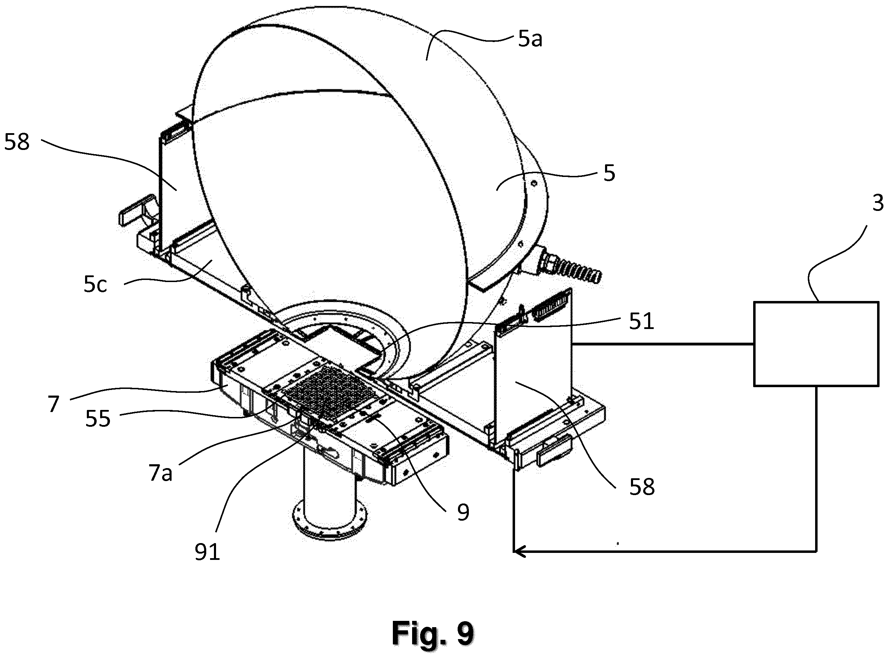

Next the test handler 7 is moved so that it is adjacent to the opening 171 in the inlet adaptor member 170 attached to the mask member 160; as shown in Figure 9.

The plunger head 7a it then extended from the test handler 7 to deliver the test array 9 in the tile 55 to the test position. Specifically the plunger head 7a is extended from the test handler 7 to move the tile 55 so to abut the inlet adaptor member 170 and so that the test array are positioned in the opening 171 of the inlet adaptor member 170. In this position the light emitting devices 91 can emit light into the light integrating sphere 5a - this position defines the test position for the test array 9. Moreover since the shape of the tile 55 corresponds to the shape of the opening 171 and since the dimensions of the tile 55 are larger than the dimensions of the opening 171, when the tile 55 abuts the inlet adaptor member 170 the tile 55 optically seals the opening 171 in the inlet adaptor member 170 which ultimately optically seals the light integrating sphere 5a from ambient light.

In the most preferred embodiment in the test position each of the light emitting device 91 in the test array 9 will extend above the opening 171, and more preferably in the test position each of the light emitting device 91 in the test array 9 will extend above the plane of the inlet adaptor member 170. This will ensure that the inlet adaptor member 170 does not obstruct any light emitted by the light emitting devices 91 in the test array 9 from entering the integrating sphere 5a. In an embodiment the plurality of inlet adaptor members from which the user selects will also have differing thicknesses, and the user will select to attach the inlet adaptor member having a thickness which is less than the height above the tile to which the test array 9 extends.

Once test handler 7 has delivered the test array 9 to the test position the vacuum generator 200 it then operated so as to generate a vacuum which holds the tile 55 in position thus maintaining the test array 9 in the test position. Specifically, once the plunger head 7a has extended from the test handler 7 to move the tile 55 to abut the inlet adaptor member 170, the vacuum generator 200 is then operated. The vacuum generated by the vacuum generator 200 flows through the conduit 169 in the mask member 160, into the second conduit 179 in the inlet adaptor member 170, and is thus applied to the tile 55 which abuts the inlet adaptor member 170, to suck the tile 55 towards the lower surface 170b of the inlet adaptor member 170. The vacuum will maintain the tile 55 in abutment with the lower surface 170b of the inlet adaptor member 170 thus maintaining the testing array 9 in the test position. Notably the vacuum will suck the tile 55 to compress the rubber strips 172 in the inlet adaptor member 170, until the tile 55 abuts with the lower surface 170b of the inlet adaptor member 170.

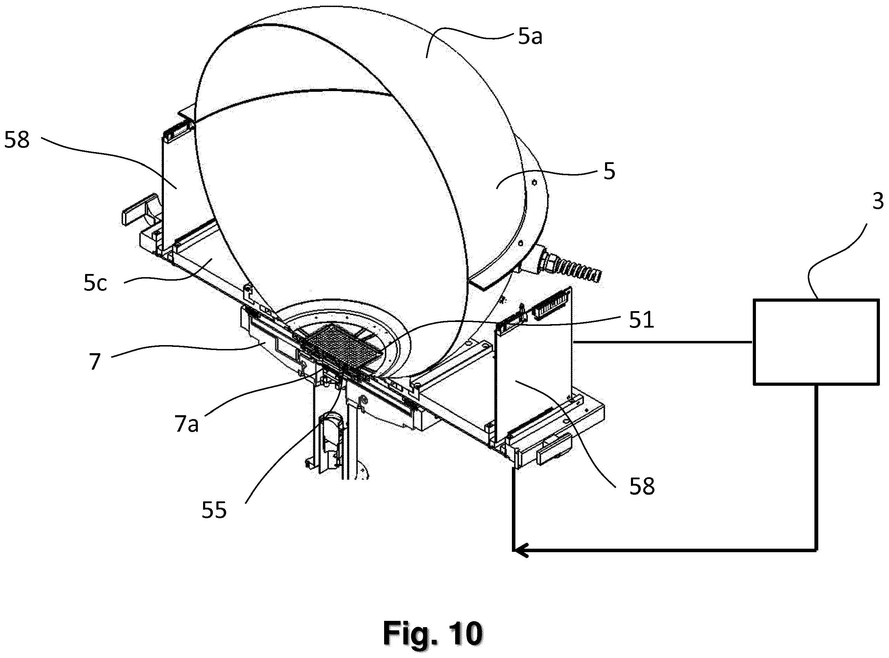

At this stage, two vacuums are being applied simultaneously to the tile 55: the vacuum which is generated by the vacuum generator 200 which sucks the tile 55 towards abutting the lower surface 170b of the inlet adaptor member 170, and, also the vacuum provides at the opening 71 on the surface 72 of the plunger head 7a which holds the tile 55 on the surface 72 of the plunger head 7a. In this embodiment, the vacuum holding the tile 55 on the surface 72 of the plunger head 7a is turned off only after the vacuum generator 200 is operated to apply a vacuum which sucks the tile 55 towards abutting the inlet adaptor member 170. At this stage the tile 55 will be held exclusively by the vacuum generated by the vacuum generator 200. Figure 10 illustrates the test array 9 having been move to the test position; and wherein the tile 55 has been positioned to optically seal the light integrating sphere 5a and is held in position exclusively by the vacuum generated by the vacuum generator 200 which sucks the tile 55 towards abutting the lower surface 170b of the inlet adaptor member 170.

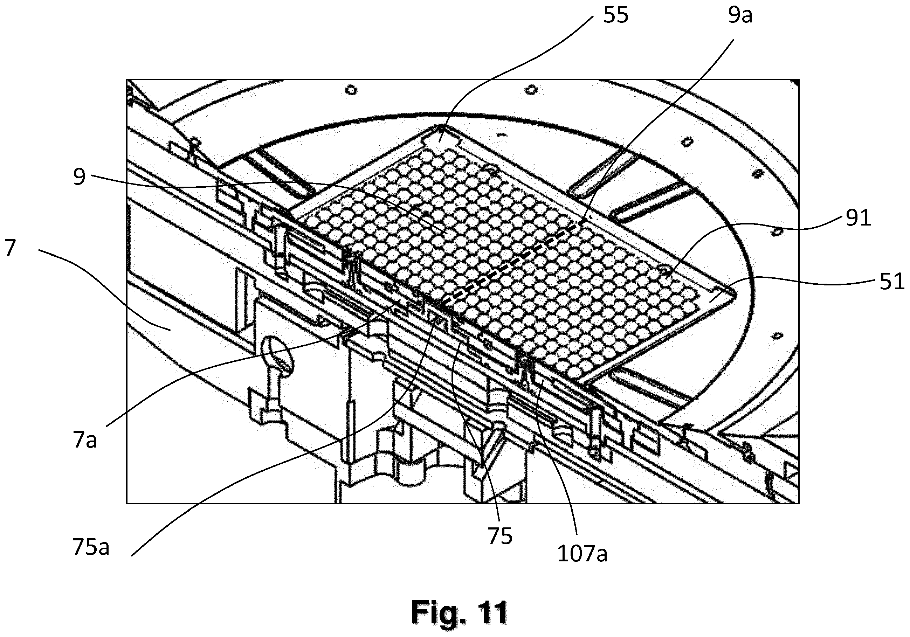

The test handler 7 is then moved so that the contact sockets 75a in the contact unit 75 on the plunger head 7a are aligned with electrical contacts of the light emitting devices in a row 9a of the test array 9. Figure 11 illustrates the test handler 7 after it has been moved so that the contact sockets 75a in the contact unit 75 are aligned with electrical contacts of the light emitting devices 91 in a row 9a of the test array 9. For illustration purposes figure 11 shows the contact sockets 75a in the contact unit 75 aligned with electrical contacts of the light emitting devices 91 in middle row 9a close to of the test array 9; however it will be understood that typically the contact sockets 75a in the contact unit 75 are first aligned with electrical contacts of the light emitting devices 91 in row which is closest to the outer edge of the test array 9, and contact sockets 75a in the contact unit 75 are then indexed along consecutive rows of the test array 9 electrical testing and optical testing the device 91 in each row.

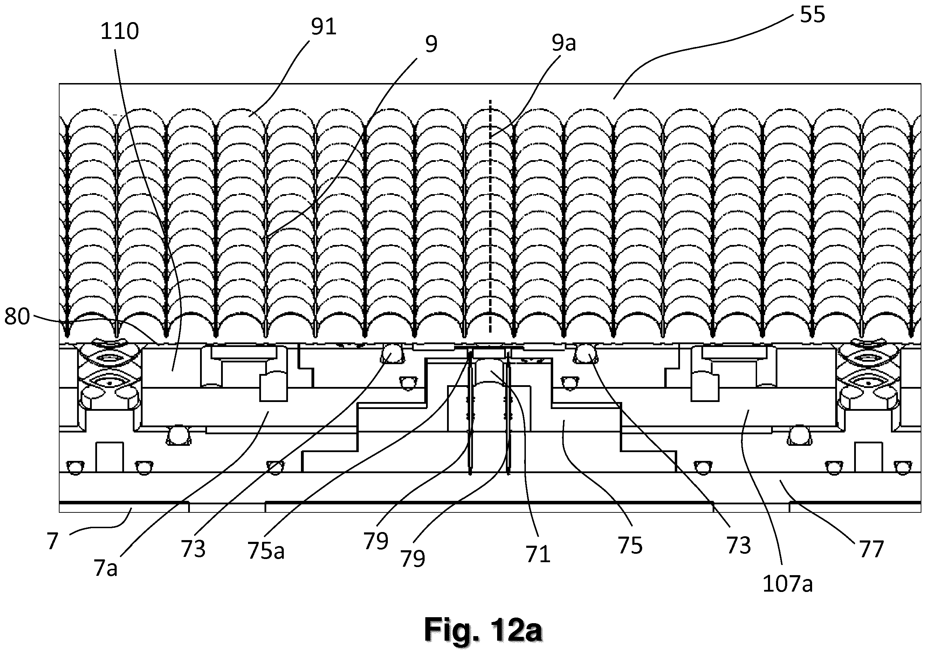

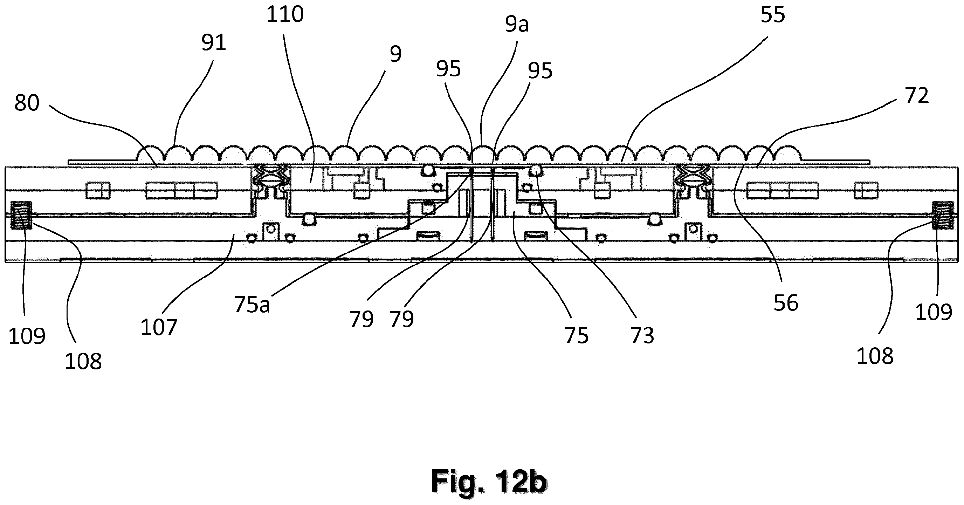

While maintaining the contact sockets 75a in alignment with electrical contacts of the light emitting devices 91 in row 9a of the test array 9, the test handler 7 is then moved so that the seals 73 on the surface 72 of the plunger head 7a abut the undersurface 56 of tile 55. Figures 12a and 12b illustrate the test handler 7 after having been moved so that the seals 73 on the surface 72 of the plunger head 7a abut the undersurface 56 of the tile 55. The seals 73 advantageously provide for damping as the test handler 7 is moved to abut the tile 55. The seals 73 further provide for an air gap 80 between the surface 71 of the plunger head 7a and the tile 55 after abutment. Importantly when the seals 73 on the surface 72 of the plunger head 7a abut the undersurface 56 of the tile 55, then the undersurface 56 of the tile 55, the seals 73, and surface 72 of platform 110 of the plunger head 7a define a chamber 81.

Figures 12a & 12b also illustrate the electrical contact pins 79 of the contact unit 75. Although the only two electrical contact pins 79 are visible in the Figures, it will be understood that a plurality of electrical contact pins 79 are provided corresponding to the plurality of contact sockets 75a illustrated in Figure 3. The plurality of electrical contact pins 79 can be selectively moved to protrude from the plurality of contact socket 75a so that they extend above the surface 72 of the plunger head 7a. Preferably the number of light emitting devices 91 provided in each row (or column) of the test array 9 is such that the sum of the number of electrical contacts 95 of all the light emitting devices 91 in row 9a is equal to the number of electrical contact pins 79 provided in the contact unit 75.

It is shown that the plunger head 7a comprises a main member 107 which has a groove 108 defined therein; biasing means 109 which in this example are in the form of spring members 109 are provided in the groove 108; a moveable platform 110 is supported on spring members 109; the platform 110 is selectively moveably against the springs 109.

After the test handler 7 has been moved so that the seals 73 on the surface 72 of the plunger head 7a abut the tile 55, the vacuum generator, which is in fluid communication with the vacuum opening 71 on the plunger head 7a, is then operated so that a vacuum is generated in the chamber 81; the vacuum is applied to an undersurface 56 of the tile 55 so that the tile 55 is moved to compresses the seals 73 and come substantially in contact with the surface 72 of the plunger head 7a. Applying the vacuum to the undersurface 56 of the tile 55, causes the electrical contact pins 79 of the contact unit 75 to pass through the plurality of contact sockets 75a to extend above the surface 72 of the plunger head 7a, and mechanically contact respective electrical contacts 95 of some or all of the light emitting devices 91 in row 9a. Specifically applying a vacuum to the undersurface 56 of the tile 55 pulls the tile 55 towards the electrical contact pins 79, which in turn pulls the moveable platform 110 of the plunger head 7a against the biasing force of the springs 108 towards the electrical contact pins 79; the electrical contact pins 79 are in a fixed position aligned with respective contact sockets 75a, accordingly as the platform 110 is moved towards the electrical contact pins 79 the electrical contact pins 79 move through respective contact sockets 75a and extend above the surface 72 of the platform 110 of the plunger head 7a, and contact the electrical contacts of the devices 91 in the test array 9. Essentially the surface 72 is moved to level of the tips of the electrical contact pins 79 so that the electrical contact pins 79 extend above the surface 72 to contact the electrical contacts of the devices 91 in the test array 9. In a variation of the embodiment the electrical contact pins 79 are configured to be moveable and can be selectively moved to extend through the contact sockets 75a to protrude above the surface 72 of the plunger head 7a; in this variation it should be understood that the plunger head 7a is not required to have a main member 107 and platform 110 which is supported on springs 108; on the contrary the plunger head 7a may have a fixed surface 72 and the electrical contact pins 79 move relative to the surface 72 to extend above the surface 72, instead of the surface 72 moving relative to the electrical contact pins 79.

In this example the electrical contact pins 79 of the contact unit 75 are moved to protrude from the plurality of contact socket 75a to extend above the surface 72 of the plunger head 7a (more specifically to extend above the surface 72 of the platform 110 of the plunger head 7a), and mechanically contact respective electrical contacts 95 of a predefined number of the light emitting devices 91 in row 9a; said 'predefined number of the light emitting devices 91' will be referred to hereafter as 'group 19 of light emitting devices 91'. In this example each row in the test array 9 (including row 9a) comprises 24 light emitting device 91; a group 19 of light emitting devices 91 comprises eight light emitting devices 91, therefore each row in the test array 9 comprises 3 groups 19. However it will be understood that the test array 9 and/or the rows of the test array could comprise any number devices; likewise the group 19 could comprise any number of light emitting devices 91.

It is pointed out that the plurality of electrical contact pins 79 in the contact unit 75 are simultaneously moved so that they mechanically contact all of the electrical contacts 95 of all the light emitting devices 91 in the group 19 at the same time. In other words, each of the plurality of electrical contact pins 79 mechanically contact a single respective electrical contact 95 of a light emitting device 91 in the group 19; all of the plurality of electrical contact pins 95 are moved simultaneously to mechanically contact a respective electrical contact 95. Accordingly at this stage all electrical contacts 95 of all the light emitting devices 91 in the group 19 are in mechanical contact with a respective electrical contact pin 79 of the contact unit 75.

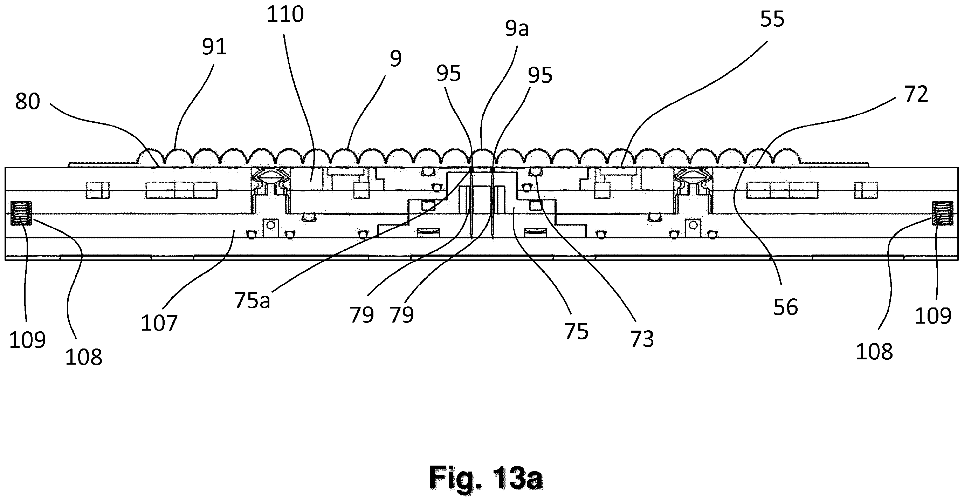

Figure 13a illustrates the tile 55 after the vacuum is applied to its undersurface 56 via the vacuum opening 71 on the surface 72 of the platform 110 of the plunger head 7a; and, shows that the platform 110 having been moved towards the electrical contact pins 79 so that the tips of the electrical contact pins 79 of the contact unit 75 protrude through the contact sockets 75a to extend above the surface 72 of the platform 110 so that the electrical contact pins 79simultaneously mechanically contact all electrical contacts 95 of the light emitting devices 91 in the group 19.

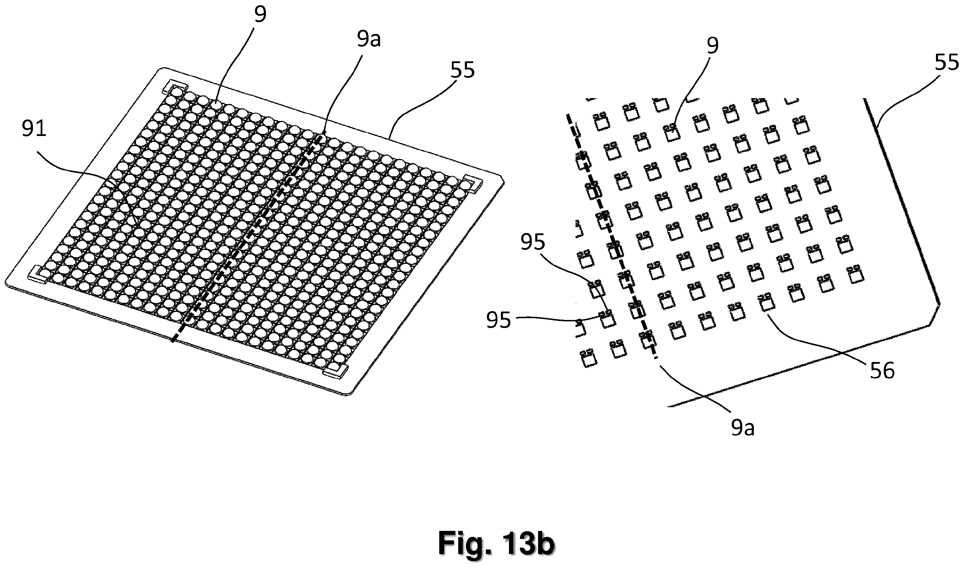

It should be understood that the tile 55 used in the present invention is configured such that the electrical contacts 95 of light emitting devices 91 supported on the tile 55 remain exposed to allow those electrical contacts 95 to be contacted by the electrical contact pins 79 provided in the contact unit 75 of the plunger head 7a. In the present invention the tile 55 is configured such that the electrical contacts 95 of light emitting devices 91 supported on the tile 55 remain exposed at an undersurface of the tile 55. Figure 13b shows a perspective view of a tile 55 on which device 91 are supported; and shows part of an undersurface 56 of the tile 55 where the electrical contacts 95 of light emitting devices 91 are exposed. Having the electrical contacts 95 of light emitting devices 91 exposed at the undersurface 56 of the tile allows the electrical contact pins 79 of the contact unit 75 to electrically contact the electrical contacts 95 of light emitting devices 91. It can also be seen that each device 91 has two electrical contacts 95; however it will be understood that each device 91 can have any number of electrical contacts 95, for example in another embodiment each device 91 can have one electrical contact 95.

It will be understood that the test control and parameter measuring unit 3 may initiate some or all of the above mentioned method steps.

Once electrical contact pins 79 of the contact unit 75 mechanically contact all electrical contacts 95 of the light emitting devices 91 in the group 19 the electrical and optical testing of the light emitting devices 91 in the group 19 can commence. Test control and parameter measuring unit 3 is responsible for carrying out the electrical and optical testing of the light emitting devices 91. In this embodiment the electrical testing of the devices in the group 19 is performed prior to optical testing of the devices in the group 19; the advantage of carrying out the electrical and optical testing in this order is that by doing electrical testing first one can forgo or skip unnecessary optical tests of devices which have already fails electrical testing. Electrical testing is carried on the group of devices in parallel so that all of the groups of devices are electrically tested simultaneously. Optical testing on the other hand is carried out consecutively on each of the individual devices in the group and therefore is time consuming. By doing the electrical testing first the system can optically test only those devices in the group which have passed the electrically testing therefore allowing more efficient use of resources as optical testing is not performed on those devices in the group which are anyway destined to be rejected for failing the electrical testing. For example if there are eight devices in a group, consider that it takes 150ms to perform electrical testing of all eight devices in the group simultaneously and 20ms to perform optical testing of one of the eight devices; in the present invention if for example four of the eight device fail the electrical testing then optical testing is performed on only the four of the eight devices which passed the electrical testing. There is thus a time saving of 80ms (4*20ms) which would otherwise have been used to test the four devices which failed the electrical testing. Accordingly in summary the advantage of carrying out the electrical and optical testing in this order is that time saving and more efficient use of resources is achieved since optically testing can be confined only to those devices which have successfully passed the electrical testing.

The electrical testing of all the light emitting devices 91 in the group 19 is carried out in parallel, so that electrical parameters of each of the light emitting devices 91 in the group 19 can be determined; and optical testing of all the light emitting devices 91 in the group 19 is carried out in a sequential device-by-device manner, so that optical parameters of each of the devices in the group can be determined.

To perform electrical testing the test control and parameter measuring unit 3 sends electrical test signals which implement the necessary electrical testing in the light emitting devices 91 in the group 19. The electrical test signals are sent from the test control and parameter measuring unit 3 to all of the electrical contact pins 79 in the contact unit 75 simultaneously, so that the test signals reach all electrical contacts 95 of all the light emitting devices 91 in the group 19 simultaneously. This enables the simultaneous electrical testing of all the light emitting devices 91 in the group 19 to be performed. The electrical responses of each light emitting device 91 to the electrical test signals are sent back to the test control and parameter measuring unit 3 where they are analyzed and processed by the test control and parameter measuring unit 3 to determine how each of the each light emitting device 91 of the group 19 performed in the electrical test.

After electrical testing of the light emitting devices 91 of the group 19 has been performed sequential optical testing of each light emitting device 91 of the group 19, device-by-device, can begin.

Optical test signals are sent from the test control and parameter measuring unit 3 only to electrical contact pins 79 in the contact unit 75 which mechanically contact the electrical contacts 95 of a single light emitting device 91 in the group 19 only, so that the electrical contacts 95 of that single light emitting device 91 in the group 19 only receives the optical test signals. When that single light emitting device 91 receives the optical test signals the single light emitting device 91 emits light into the light integrating sphere 5a. The emitted light is collected by the light integrating sphere and values representing the amount and direction of the light collected is generated and sent to the test control and parameter measuring unit 3 where they are analyzed and processed by the test control and parameter measuring unit 3 to determine optical parameters of that single light emitting device 91. These steps are performed for each of the light emitting devices 91 in the group 19 until all the light emitting devices 19 in the group have been individually optically tested independent of one another i.e. the each of the light emitting devices 91 in the group 19 is optically tested at a different time. Thus after optical testing of the devices 91 in the group 91 and optical parameters of each of the device 91 will have been determined.

In one embodiment a multiplexer 58 is provided in the test arrangement 1 which has a plurality of outputs each of which is electrically connected to a respective electrical contact pin 79 in the contact unit 75 and an input which is electrically connected to the test control and parameter measuring unit 3. The multiplexer is used to selectively address each of the electrical contact pins 79 in the contact unit 75 and thus is operable to send the optical test signals to a selected light emitting device 91 in the group 19. For example, if the first light emitting device is to be optically tested; then the optical test signals are sent from the test control and parameter measuring unit 3 to the multiplexer; the test control and parameter measuring unit 3 then controls the multiplexer so that the optical test signals are passed to the output of the multiplexer which is electrically connected to the electrical contact pins 79 in the contact unit 75 which mechanically contact the electrical contacts 95 of the first light emitting device 91 in the group 19, so that the electrical contacts 95 of the first light emitting device 91 in the group 19 only receives the optical test signals. The test control and parameter measuring unit 3 controls the multiplexer so that optical test signals are sent, to each light emitting device 91 in the group 19, so that each of the light emitting devices 91 in the group 19 can be individually optically tested independently of the other devices 91 in the group 19.

It will be understood that any electrical testing and optical testing may be carried out in the present invention; the electrical testing may involve testing for any electrical parameters of the light emitting devices 91 and the optical testing may involve testing for any optical parameters of the light emitting devices 91. The electrical testing typically involve performing electrical tests which are designed to determine if the device is functioning as expected, if the device is mechanically functional (e.g. that the device was fabricated without flaws) and to determine if the part can operate under normal conditions. For example the devices will typically be LEDs each of which have two pads (i.e. two electrical contacts); to perform electrical testing the electrical contact pins 79 in the contact unit 75 define positive and negative probes which are arranged to electrically contact the two pads of respective LEDs. Once the LED pads are contacted by the probes the test control and parameter measuring unit 3 ill initiate a predefined current or voltage to pass through the LED and this will cause the LED to light up. The test control and parameter measuring unit 3 will measure the voltage in and voltage out of each respective LED and can calculate the resistance of that LED. Knowing all of these values the test control and parameter measuring unit 3 can determine if each respective LED was manufactured properly, for example: If the test control and parameter measuring unit 3 measures a voltage across the LED and the voltage in is a known controlled input voltage but the voltage out is at 0, then the test control and parameter measuring unit 3 would indicate that the LED is not functioning properly and the mechanical connection inside the LED has failed and the LED will not light up; therefore the LED will be deemed to have failed the electrical test. If on the other hand the test control and parameter measuring unit 3 measures voltage out to be exactly the same as voltage in then the test control and parameter measuring unit 3 will determine that the LED has a short or that the two electrical contacts 95 are electrically connected or touching, and therefore the LED will be deemed to have failed the electrical test. Optical testing is performed on those devices which have passed the electrical testing. The optical testing may involve applying a known voltage and current to the LED's in the group respectively so that each LED consecutively lights up inside the sphere. The properties of the light integrating sphere collect the light emitted, and then using a spectrometer or spectroradiometer test control and parameter measuring unit 3 then extracts predefined properties of the light collected by light integrating sphere and compares those extracted properties to corresponding properties of a reference light emitted by an reference LED (which provides optimal LED performance). After the comparison the LED under test would be categorized according to extracted properties.

Once all the light emitting devices 91 the group 19 have been electrically and optically tested, the test handler 7 is then moved so that the next group of eight light emitting devices in the first row 9a can be electrically and optically tested in the same manner as described above. This is repeated until all the groups of light emitting devices 91 in the first row of the test array 9 are electrically and optically tested; after which the test handler 7 is then moved so that the groups 19 in the other remaining rows of the test array 9 can be electrically and optically tested in the same manner as described above.

Importantly in this embodiment the test array 9 remains in the same single fixed position during the optical testing of all the light emitting devices 91 in the test array 9. In this embodiment the test array 9 also remains in the same single fixed position during the electrical testing of all the light emitting devices 91 in the test array 9. Thus the test array is never moved from its original test position during electrical and optical testing of all devices 91 in the test array 9. Thus the optical testing and electrical testing of all the light emitting devices in the test array 9 is performed without moving the test array 9 from the initial test position to which it was initially brought. Since each light emitting device 91 occupies a different position in the test array 9 and since the test array 9 remains in a single fixed position during the optical testing, each individual light emitting device will be located in a different position with respect to the center of the light integrating sphere 5a when optical testing is performed. The differing positions with respect to the center of the light integrating sphere 5a will mean that different parts of the light integrating sphere 5a will receive more light than other parts depending on the position of the light emitting device 91 which is being tested.

In order to address this test control and parameter measuring unit 3 is configured to perform a post-processing of the measured optical parameters for each light emitting device according to the individual positions of that device relative to the center of the integrating sphere. In order to post process the optical parameters, offsets corresponding to the position of the respective light emitting device relative to the center of the integrating sphere, are added to the measured optical parameters.

For example a look-up-table having a list of positions for devices in the test array relative to center of the light integrating sphere 5a and a corresponding offset for each position entry in the look-up-table; each offset is a predetermined value which is to be added to optical parameters measured during the optical testing to compensate for the position of device being offset from the center of the light integrating sphere. Thus when optical testing of a device have been performed the test control and parameter measuring unit 3 determines the position of that light emitting device relative to the center of the integrating sphere; the test control and parameter measuring unit 3 then retrieves the offset from the look-up-table which corresponds to the determined position and the retrieved offset is added to optical parameters measured for that device so as to compensate for the position of device being offset from the center of the light integrating sphere. This is done for each of the devices in the group 19 (and each device of subsequently optically tested groups; and ultimately for all devices in the test array 9); accordingly optical testing of all devices in a whole test array can be tested without having to move the tile within the light integrating sphere 5a.

The look-up-table is formed during a calibration step which involves positioning light emitting devices which have known optical parameters, at each of the positions relative to the center of the integrating sphere where light emitting devices under test are due to be positioned. The positions of each of the light emitting devices is noted in the look-up-table. The optical testing is then performed consecutively on each of the light emitting devices, for each device emitted light is collected by the light integrating sphere 5a; values representing the amount and direction of the light collected is generated and sent to the test control and parameter measuring unit 3 where they are analyzed and processed by the test control and parameter measuring unit 3 to determine measured optical parameters of each individual light emitting device 91. For each device the determined measured optical parameters are then compared to the known optical parameters for that device, and for each device the difference between the determined measured optical parameters for that device and the known optical parameters for that device defines the offset which is to be added measured optical parameters to compensate for the position of device being offset from the center of the light integrating sphere.

Preferably the number of said light emitting devices which have known optical parameters correspond to the number of devices which are due to be in the test array 9; and preferably be arranged on a tile identical to the tile on which the test array is due to be positioned, in the same arrangement as the arrangement of the devices which are due to be in the test array 9. However in the event that the number and/or arrangement of the devices in the test array 9 are different to the number and/or arrangement of said light emitting devices which have known optical parameters used in the calibration step then interpolation of the offset values in the look-up-table can be used to determine the values of the offsets which is to be added measured optical parameters to compensate for the position of devices being offset from the center of the light integrating sphere. For example: if said light emitting devices which have known optical parameters were arranged in a 20 x 20 matrix on a tile (i.e. 20 devices along each column and 20 devices along each row) (at for example 4mm pitch from LED to LED in a line) then the look-up-table would have 400 offset entries corresponding to each of the 400 different positions relative to the center of the light integrating sphere, of the 400 light emitting devices on the tile. If on the other hand the devices which are to undergo optical testing are arranged in a 40 x 40 matrix on a tile (i.e. 40 devices along each column and 40 devices along each row)(at for example 2mm pitch) then there would be 800 devices having 800 different positions relative to the center of the light integrating sphere; the offset to apply to each of the measured optical parameters for 400 of those devices can be read directly from the look-up-table based on their respective positions relative to the center of the light integrating sphere, and for each of the remaining 400 devices linear interpolation of the offset values in the look-up-table, according to their respective positions relative to the center of the light integrating sphere, can be used to calculate the offset which is to be added to their respective measured optical parameters to compensate for their respective positions being offset from the center of the light integrating sphere. In another embodiment no interpolation is performed, rather for each device the test control and parameter measuring unit 3 identifies the position entry in the look-up-table which is closest to the position of the device and the offset which corresponds to the identified position is added to the measured optical parameter for that device to compensate for the position of that device being offset from the center of the light integrating sphere.

In yet another embodiment no offset is added to the measured optical parameter devices to compensate for the position of that device being offset from the center of the light integrating sphere. This may be the case when the offset of the devices with respect to the center of the light integrating sphere has a negligible effect on the optical measurements; accordingly the optical measurements do not need to be adjusted to compensation for the offset position of the devices. One example would be when, for example, when each of the devices of the test array are within 5 mm of the center of the light integrating sphere; in this example each of the devices in the test array are close enough to the center of the light integrating sphere that its offset from the center of the light integrating sphere has a negligible effect on the measured optical parameters.

As mentioned the light emitting devices which have known optical parameters, which are used in the calibration step are arranged on a tile. For the calibration step the tile should be positioned at a predefined position in the light integrating sphere 5a; the predefined position will also be the position in which the tile on which devices to be tested will be arranged when the test array 9 are in the testing position. A camera is provided on the plunger head 7a which can be used to position the tile with light emitting devices which have known optical parameters into the predefined position in the light integrating sphere 5a. The light integrating sphere 5a comprises fiducials which indicate the centre of the light integrating sphere 5a the tile with light emitting devices which have known optical parameters also comprise fiducials which which indicate the centre of the tile. The camera first captures a first image of the fiducials on the light integrating sphere, and determines from the first image the position of the centre of the light integrating sphere 5a within a predefined reference frame; next the camera captures a second image of the fiducials on the tile, and determines from the second image the position of the centre of the tile within the predefined reference frame. When both positions are known it can be determined how the tile should be moved so that the tiles centre is aligned with the centre of the light integrating sphere 5a.

During testing the position of the centre of the light integrating sphere 5a within the predefined frame of is typically determined only once. The positions of different tiles which carry devices to be tested, within the predefined frame is determined each time a new tile is presented which has new devices for test, so that the tiles position relative to the centre of the light integrating sphere 5a can be determined (which enables determining how the tile should be moved to bring it to the centre of the light integrating sphere 5a).

Preferably the dimensions of the tile on which the devices to be tested are provided are predefined. The predefined tile dimensions can be used to determine the position of the devices relative to the center of the light integrating sphere 5a. The user must enter in the size of the device, the x pitch (device to device distance), the y pitch (device to device distance), the number of devices in a column and in a row, and the xy distance of the two fiducials from the center of the LED device pattern. Knowing these values the exact position of each device on a tile relative to the centre of the light integrating sphere can be calculated so that the appropriate offset to add to the measure optical parameters to compensate for the position of device, can be retrieved from the look-up-table.

The above example illustrates an assembly according to the present invention, which comprises a carrier 7 in the form of a test handler 7, being used to perform a method according to the present invention. It will be understood that an assembly according to the present invention, which comprises a carrier 7 in the form illustrated in Figure 5 above, may also be used to perform a method according to the present invention: In this case electrical and optical testing is performed in the same manner as above, along with the optional post processing of the optical parameters. However the manner in which the light emitting devices 91 are moved to the test position is different:

The rotary table is first rotated about the rotary axis 154 so as to move one of the nests 151 into a loading area where light emitting devices 91 can be loaded onto the flat surface 153 of that nest 151. Once the nest 151 has been moved to the loading area the vacuum generating means which is fluidly connected with the vacuum openings 156 of that nest 151 is then operated to provide a vacuum at the flat surface 153 of the nest 151.

Light emitting devices 91 are loaded onto each of the designated areas 155 on flat surface 153 of a nest 151 on the rotary table 150. The plurality of light emitting devices 91 located on the flat surface 153 of the nest constitute a group 19 of light emitting devices. When a light emitting device 91 is positioned at a designated area 155 the vacuum will hold that device in the designated area 155 in which is was placed; furthermore the electrical contacts of the light emitting device 91 will contact the electrical contact platforms 158 of that designated area 155.

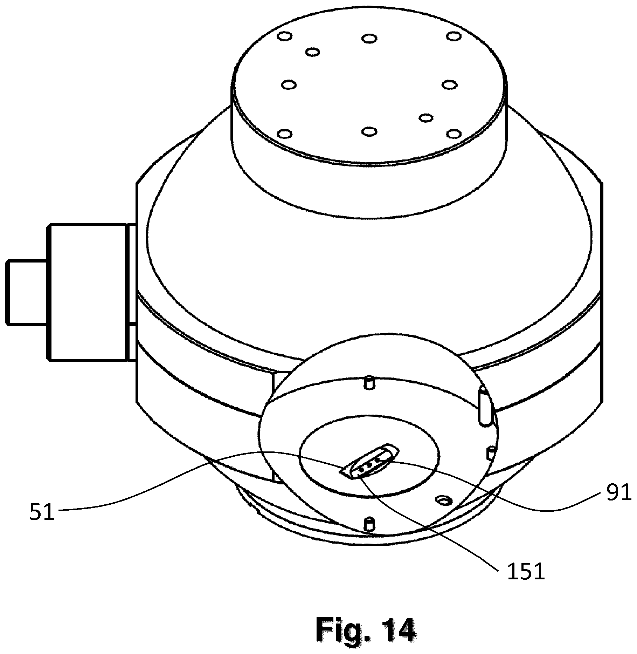

Next the rotary table 150 is rotated about the rotary axis 154 to move the nest 151 on which light emitting device 91 have been loaded, so that the nest 151 is aligned with the inlet window 51. When the nest 151 has been moved so that the nest 151 is aligned with the inlet window 51 the light emitting devices 91 will be in the test position. When the nest 151 is aligned with the inlet window 51 the light emitting devices 91 will extend above an inner surface 135 of the light integrating sphere 5a. It should be noted that in this embodiment no sealing ring 53 is provided in the assembly and the inlet window 51 is defined in light integrating sphere 5a. Figure 14 illustrates the assembly after the rotary table 150 has been rotated about the rotary axis 154 to move the nest 151 on which light emitting device 91 have been loaded, so that the nest 151 is aligned with the inlet window 51. In Figure 14 a part-cut-away portion of the integrating sphere is provided so as provide an illustration of inside of the sphere 5a.

In another embodiment the light integrating sphere 5a comprises a sealing ring 53; in that embodiment the rotary table 150 is rotated about the rotary axis 154 to move the nest 151 on which light emitting device 91 have been loaded, so that the nest 151 abuts the sealing ring 53. the is rotated about the rotary axis 154 to move the nest 151 on which light emitting device 91 have been loaded, so that the nest 151 abuts the sealing ring 53. When the nest 151 abuts the sealing ring 53 the light emitting devices 91 will be in the test position. In a further variation of this embodiment the rotary table 150 is rotated about the rotary axis 154 to move the nest 151 on which light emitting device 91 have been loaded, so that the nest 151 abuts portion of the integrating sphere 5a in which the inlet window 51 is defined. When the nest 151 has been so that the nest 151 abuts portion of the integrating sphere 5a in which the inlet window 51 is defined the light emitting devices 91 will be in the test position. In all embodiments when the nest 151 is aligned with the inlet window 51, or when the nest 151 abuts portion of the integrating sphere 5a in which the inlet window 51 is defined, the light emitting devices 91 will extend above an inner surface of the light integrating sphere 5a.

In another embodiment the integrating sphere 5a first rotates about the rotary axis 154 so that the nest 151 is directly aligned below the inlet window 51 of the light integrating sphere 5a; and then the rotary table 150 is then moved linearly (i.e. moved in a direction parallel to the rotary axis 154) to move the nest 151 towards the inlet window 51, until the nest 151 abuts the integrating sphere 5a; specifically rotary table 150 is then moved linearly (i.e. moved in a direction parallel to the rotary axis 154) to move the nest 151 towards the inlet window, until the nest 151 abuts sealing ring 53 of the integrating sphere 5a. In one embodiment when the nest 151 abuts the sealing ring 53 it will optically seal the inlet window 51. In a preferred embodiment the shape and dimensions of the flat surface 153 of the nest 151 match (or are slightly larger than) the shape and dimension of the inlet opening 51 so that the nest 1 can optically seal the inlet window 51 when it is moved to abut the integrating sphere.

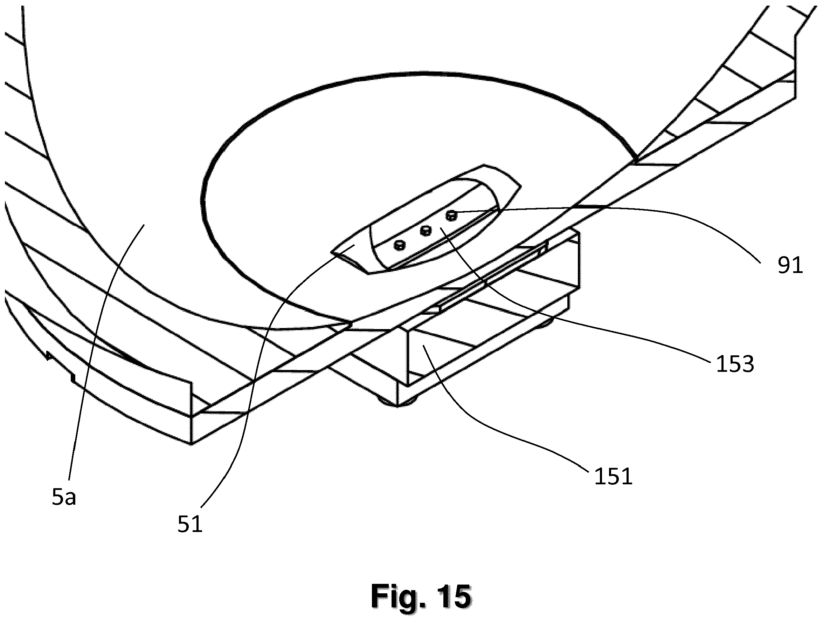

Figure 15 provides a magnified view of the nest 151 on which light emitting devices 91 have been loaded, which is aligned with the inlet window 51 of the light integrating sphere 5a. The light emitting devices 91 extend above the inner surface 135 of the light integrating sphere 5a; and the intermediate electrical contact 160 provided in the nest 151 remain outside of the integrating sphere 5a. The inlet window 51 is shown to be rectangular shaped; the flat surface 153 of the nest 151 is also rectangular shaped and has a length and width dimensions which is larger than the respective length and width dimensions of the inlet window 51; this allows the nest 151 prevent at least some light (which has been emitted into the light integrating sphere 5a by the light emitting devices 91) from leaking out of light integrating sphere 5a. It is preferable that the dimensions and shape of the flat surface 153 are such that the full perimeter of the inlet window 51 can be fully contained within the perimeter of the flat surface 153 of the nest 151. It will be understood that it is not essential that the flat surface 153 have the same shape as the inlet window 53. In one embodiment the shape and dimension of the nest 151 will correspond to the shape and dimension of the inlet window 51 so that the nest 151 can optically seal the inlet window 51, however this is not essential.

Next electrical and optical testing of the light emitting devices 91 is then performed in the same manner as described above for the previous embodiment. The electrical signals which implement the electrical and/or optical testing are sent by the control and parameter measuring unit 3 to electrical contacts which are present at each of the designated areas 155 on the nest 151 where they are received by the electrical contacts of the light emitting devices 91.

The embodiments and aspects of the invention explained above are not determined to limit the scope of the invention, which is exclusively to be determined by the attached claims. Many modifications of the inventive concept are possible within the scope of the claims and, more specifically, arbitrary combinations of the several claim features are considered to be within the scope of the invention.

## Claims

1. An assembly for testing optical devices, the assembly comprising,
a light integrating sphere (5a);
**characterized in that** the assembly further comprises,
a mask member (160) defining an inlet window (51) for the light integrating sphere (5a); and
a plurality of inlet adaptor members (170), each of which can be selectively arranged to cooperate with the mask member (160) so as to modify the amount of the inlet window (51) through which light can pass into the light integrating sphere (5a), and wherein each the plurality of inlet adaptor members (170) comprise openings (171) having different shapes and/or dimensions.

2. An assembly according to claim 1 further comprising a plurality of tiles, on each of which a test array composed of devices for testing can be provided, wherein the dimensions of each respective tile are larger than the dimensions of an opening provided in a respective inlet adaptor member, so that each of the plurality of tiles can optically seal the opening in a respective inlet adaptor member when the respective tile is moved to abut said respective inlet adaptor member.

3. An assembly according to claim 1 or 2 wherein the mask member further comprises a conduit and each of the plurality of inlet adaptor members comprise a second conduit, wherein the second conduit of any one of the inlet adaptor members is in fluid communication with the conduit of the mask member when that inlet adaptor member is selectively removably attached to the mask member, and wherein there is further provided a vacuum generator which can be selectively fluidly connected with the conduit in the mask member.

4. An assembly according to any one of claims 1 - 3 wherein the assembly further comprises a carrier having a plunger head on the surface of which a tile having a test array, can be supported,
wherein the carrier further comprises,
a seal which extends above the surface of the plunger head; and one or more vacuum openings defined in the surface of the plunger head through which a vacuum can flow to suck a tile in a direction towards the surface of the plunger head, and wherein the seal is arranged to surround the one or more vacuum openings; and
electrical contact pins which can be selectively extended above the surface of the plunger head to electrically contact devices in the test array.

5. A method for handling a group of optical devices which are to undergo optical testing, wherein the group comprises more than one optical device, **characterized in that** the method comprises the steps of,
identifying the dimension and/or shape of a tile (55) on which the group of optical devices to be tested is provided;
selecting from the plurality of inlet adaptor members (170), an inlet adaptor member (170) having an opening (171) which has a dimension which is smaller than the dimensions of the tile (55) and/or which has a shape corresponding to the shape of the tile (55);
arranging the selected inlet adaptor member (170) to cooperate with the mask member (160) so as to modify the amount of the inlet window (51) through which light can pass into the light integrating sphere (5a);
moving the tile (55) so that the group of optical devices is moved into the opening (171) in the inlet adaptor member (170) so that they are in a test position, and so that the tile (55) abuts the inlet adaptor member (170) to optically seal the opening (171) thereby optically sealing the light integrating sphere (5a).

6. A method according to claim 5 wherein the step of arranging the selected inlet adaptor member to cooperate with the mask member so as to modify the amount of the inlet window through which light can pass into the light integrating sphere, comprises removably attaching the selected inlet adaptor member to the mask member, wherein the inlet adaptor member overlays the inlet window when removably attached to the mask member.

7. A method according to claim 5 or 6 further comprising the step of, selecting a tile from a plurality of tiles having different dimensions and/or shapes and, and providing a group of optical devices to be tested on the selected tile.

8. A method according to any one of claims 5-7 comprising the step of applying a vacuum to the tile to hold the tile in abutment with the inlet adaptor member, so that the group of optical devices are maintained in the test position.

9. A method according to any one of claims 5 - 8 comprising using a carrier to move the tile to abut the inlet adaptor member, wherein the carrier comprises a plunger head on which the tile can be supported, and wherein said step of using a carrier to move the tile to abut the inlet adaptor member comprise the steps of,
positioning a tile in which the group of optical devices to be tested is provided, on the plunger head;
moving the carrier such that the plunger head and tile are located beneath the inlet adaptor member and centered with respect to the opening in the inlet adaptor member;
moving the plunger head so that the tile abuts the inlet adaptor member and optically seals the opening in the inlet adaptor member.

10. A method according to any one of claims 5 - 9 comprising the steps of,
applying a vacuum to the tile which sucks the tile towards the plunger head; and
simultaneously applying a vacuum to the tile to hold the tile in abutment with the inlet adaptor member;
and subsequently removing the vacuum which sucks the tile towards the plunger head so that the vacuum which holds the tile in abutment with the inlet adaptor member is exclusively applied to the tile.

11. A method according to any one of claims 5 - 10 comprising the steps of,
applying a vacuum to the tile to hold the tile in abutment with the inlet adaptor member;
extending said plurality of electrical contact pins above a surface of the plunger head, so that the electrical contact pins mechanically contact the electrical contacts of devices in the group, wherein the group comprises more than one device;
applying a vacuum to the tile to suck the tile towards the plunger head.

12. A method according to any one of claims 1-11, comprising, providing a carrier having a plunger head on the surface of which a tile having a test array can be supported, the carrier further comprising, a seal which extends above a surface of the plunger head; and one or more vacuum openings defined in the surface of the plunger head through which a vacuum can flow to suck a tile in a direction towards the surface of the plunger head, and wherein the seal is arranged to surround the one or more vacuum openings; and electrical contact pins which can be selectively extended above the surface of the plunger head to electrically contact devices in the test array;
wherein the method comprises,
applying a vacuum to the tile to hold the tile in abutment with the inlet adaptor member;
moving the plunger head of the carrier so that the seal abuts an undersurface of the tile , so that the surface of the plunger head, the undersurface of the tile and the seal cumulatively define a chamber;
extending said plurality of electrical contact pins above the surface of the plunger head, so that the electrical contact pins mechanically contact the electrical contacts of devices in the group;
providing a vacuum in said chamber so that a vacuum is applied to the undersurface of the tile to suck the tile towards the plunger head, to cause electrical contacts of devices in the group to push against the electrical contact pins of the plunger head.

13. A method according to claim 11 or 12 wherein the steps of extending said plurality of electrical contact pins and applying a vacuum to the tile to suck the tile towards the plunger head are carried out simultaneously.

14. A method according to any one of claims 5-13 further comprising the steps of,
performing electrical testing of all the devices in the group simultaneously to determine simultaneously if each of the devices in the group have a predefined electrical property, and
performing optical testing on only those devices in the group which were determined to have said predefined electrical property, to determine if the devices have a predefined optical property, and wherein said optical testing of said devices is performed consecutively on said devices.

15. A method according to any one of claims 5-14 further comprising the steps, of
providing a second tile in which another group of optical devices to be tested is provided, the second tile having a shape and/or dimension different to said tile (55);
selecting from the plurality of inlet adaptor members (170), an second inlet adaptor member having an opening which has a shape corresponding to the shape of the second tile and dimensions which are smaller than the dimensions of the second tile ;
removing the inlet adaptor member (170) which is in cooperation with the mask member, and arranging the second inlet adaptor member so that it cooperates with the mask member;
moving the second tile so that the other group of optical devices is moved into the opening in the second inlet adaptor member so that they are in a test position, and so that the second tile abuts the second inlet adaptor member and optically seals the opening thereby optically sealing the light integrating sphere (5a).

## Patentansprüche

1. Anordnung zur Prüfung optischer Vorrichtungen, wobei die Anordnung umfasst:
eine lichtintegrierende Kugel (5a);
**dadurch gekennzeichnet, dass** die Anordnung zudem umfasst:
ein Abdeckglied (160), welches ein Einlassfenster (51) für die lichtintegrierende Kugel (5a) definiert; und
eine Vielzahl von Einlassanpassungsgliedern (170), wobei jedes davon selektiv angeordnet werden kann, um mit dem Abdeckglied (160) zusammenzuarbeiten, um den Menge des Einlassfensters (51) zu ändern, durch die Licht in die lichtintegrierende Kugel (5a) durchfliessen kann, und wobei die Vielzahl von Einlassanpassungsgliedern (170) Öffnungen (171) aufweisen, welche verschiedene Formen und/oder Grössen aufweisen.

2. Anordnung gemäss Anspruch 1, zudem umfassend eine Vielzahl von Platten, worauf auf jeder jeweils ein aus Testvorrichtungen bestehendes Test-Array vorgesehen werden kann, worin die Dimensionen jeder jeweiligen Platte grösser als die Dimensionen einer in einem jeweiligen EinlassAdapterglied vorgesehenen Öffnung sind, so dass jede der Vielzahl von Platten die Öffnung in einem jeweiligen Einlassadapterglied optisch abdichten kann, wenn die jeweilige Platte verschoben wird, um gegen das besagte jeweilige Einlassadapterglied anzuliegen.

3. Anordnung gemäss Anspruch 1 oder 2, worin das Abdeckglied zudem eine Leitung umfasst und jedes der Vielzahl von Einlassadaptergliedern eine zweite Leitung umfasst, worin die zweite Leitung jedes beliebigen Einlassadapterglieds in Fluidverbindung mit der Leitung des Abdeckglieds steht, wenn dieses Einlassadapterglied selektiv entfernbar mit dem Abdeckglied verbunden ist, und worin zudem ein Vakuumgenerator vorgesehen ist, welcher selektiv mit der Leitung im Abdeckglied in Fluidverbindung gesetzt werden kann.

4. Anordnung gemäss irgendeinem der Ansprüche 1 bis 3, worin die Anordnung zudem einen Träger mit einem Kolbenstopfen umfasst, auf dessen Oberfläche eine Platte mit einem Test-Array getragen werden kann,
worin der Träger zudem umfasst:
eine Dichtung, welche sich über die Oberfläche des Kolbenstopfens erstreckt;
und eine oder mehrere Vakuumöffnungen, welche in der Oberfläche des Kolbenstopfens definiert sind, und durch welche ein Vakuum fliessen kann, um eine Platte in Richtung der Oberfläche des Kolbenstopfens zu saugen, und worin die Dichtung angeordnet ist, um die eine oder mehreren Vakuumöffnungen zu umgeben; und
elektrische Kontaktstifte, welche selektiv über die Oberfläche des Kolbenstopfens hinausgeschoben werden können, um Vorrichtungen im Test-Array elektrisch zu kontaktieren.

5. Verfahren zur Behandlung einer Gruppe von optischen Vorrichtungen, welche eine optische Prüfung zu unterlaufen haben, worin die Gruppe mehr als eine optische Vorrichtung umfasst, **dadurch gekennzeichnet, dass** das Verfahren die folgenden Schritte umfasst:
Identifizieren der Grösse und/oder Form einer Platte (55), auf welcher die Gruppe der zu testenden optischen Vorrichtungen zur Verfügung gestellt wird;
aus der Vielzahl von Einlassadaptergliedern (170), Auswählen eines Einlassadapterglieds (170) mit einer Öffnung (171), welche eine kleinere Dimension als die Dimensionen der Platte (55) aufweist und/oder welche eine Form hat, welche der Form der Platte (55) entspricht;
Anordnen des ausgewählten Einlassadapterglieds (170), um mit dem Abdeckglied (160) zusammenzuarbeiten, um die Menge des Einlassfensters (51) zu ändern, durch die Licht in die lichtintegrierende Kugel (5a) durchfliessen kann;
Verschieben der Platte (55), so dass die Gruppe von optischen Vorrichtungen in die Öffnung (171) in dem Einlassadapterglied (170) verschoben wird, so dass sie sich in einer Testposition befinden, und so dass die Platte (55) an dem Einlassadapterglied (170) anliegt, um die Öffnung (171) optisch abzudichten und somit die lichtintegrierende Kugel (5a) optisch abzudichten.

6. Verfahren gemäss Anspruch 5, worin der Schritt des Anordnens des ausgewählten Einlassadapterglieds (170), um mit dem Abdeckglied (160) zusammenzuarbeiten, um die Menge des Einlassfensters (51) zu ändern, durch die Licht in die lichtintegrierende Kugel (5a) durchfliessen kann, es umfasst, dass das ausgewählte Einlassadapterglied entfernbar mit dem Abdeckglied verbunden wird, worin das Einlassadapterglied das Einlassfenster abdeckt, wenn es entfernbar mit dem Abdeckglied verbunden ist.

7. Verfahren gemäss Anspruch 5 oder 6, zudem mit dem Schritt des Auswählens einer Platte aus einer Vielzahl von Platten mit verschiedenen Grössen und/oder Formen, und der Zurverfügungstellung einer Gruppe von zu testenden optischen Vorrichtungen auf der ausgewählten Platte.

8. Verfahren gemäss irgendeinem der Ansprüche 5 bis 7, mit dem Schritt der Anwendung eines Vakuums auf die Platte, um die Platte gegen das Einlassadapterglied anzulegen, so dass die Gruppe von optischen Vorrichtungen in der Testposition gehalten werden.

9. Verfahren gemäss irgendeinem der Ansprüche 5 bis 8, mit der Verwendung eines Trägers, um die Platte zu verschieben, damit sie gegen das Einlassadapterglied anzuliegen kommt, worin der Träger einen Kolbenstopfen umfasst, auf welchem die Platte getragen werden kann, und worin der besagte Schritt der Verwendung eines Trägers, um die Platte zu verschieben, damit sie gegen das Einlassadapterglied anzuliegen kommt, die folgenden Schritte umfasst:
Positionieren einer Platte, auf welcher die Gruppe von zu testenden optischen Vorrichtungen zur Verfügung gestellt werden, auf den Kolbenstopfen;
Verschieben des Trägers derart, dass der Kolbenstopfen und die Platte sich unter dem Einlassadapterglied befinden und in Bezug auf die Öffnung in das Einlassadapterglied zentriert ist;
Verschieben des Kolbenstopfens, so dass die Platte gegen das Einlassadapterglied anliegt und die Öffnung in das Einlassadapterglied optisch abdichtet.

10. Verfahren gemäss irgendeinem der Ansprüche 5 bis 9, mit den folgenden Schritten:
Anwendung eines Vakuums auf die Platte, welches die Platte gegen den Kolbenstopfen saugt; und
gleichzeitig Anwendung eines Vakuums auf die Platte, um die Platte gegen das Einlassadapterglied anliegend zu halten;
und anschliessend Entfernen des Vakuums, welches die Platte gegen den Kolbenstopfen saugt, so dass das Vakuum, welches die Platte anliegend gegen das Einlassadapterglied hält, exklusiv an die Platte angelegt wird.

11. Verfahren gemäss irgendeinem der Ansprüche 5 bis 10, mit den folgenden Schritten:
Anwendung eines Vakuums auf die Platte, um die Platte anliegend gegen das Einlassadapterglied zu halten;
Hinausschieben der besagten Vielzahl von elektrischen Kontaktstiften über eine Oberfläche des Kolbenstopfens, so dass die elektrischen Kontaktstifte die elektrischen Kontakte der Vorrichtungen in der Gruppe mechanisch kontaktieren, worin die Gruppe mehr als eine Vorrichtung umfasst;
Anwendung eines Vakuums auf die Platte, um die Platte gegen den Kolbenstopfen zu saugen.

12. Verfahren gemäss irgendeinem der Ansprüche 1 bis 11, umfassend die Zurverfügungstellung eines Trägers mit einem Kolbenstopfen, auf dessen Oberfläche eine Platte mit einem Test-Array getragen werden kann, wobei der Träger zudem umfasst: eine Dichtung, welche sich über die Oberfläche des Kolbenstopfens erstreckt; und eine oder mehrere Vakuumöffnungen, welche in der Oberfläche des Kolbenstopfens definiert sind, und durch welche ein Vakuum fliessen kann, um eine Platte in Richtung der Oberfläche des Kolbenstopfens zu saugen, und worin die Dichtung angeordnet ist, um die eine oder mehreren Vakuumöffnungen zu umgeben; und elektrische Kontaktstifte, welche selektiv über die Oberfläche des Kolbenstopfens hinausgeschoben werden können, um Vorrichtungen im Test-Array elektrisch zu kontaktieren;
worin das Verfahren umfasst:
Anwendung eines Vakuums auf die Platte, um die Platte anliegend gegen das Einlassadapterglied zu halten;
Verschieben des Kolbenstopfens des Trägers derart, dass die Dichtung gegen eine Unterfläche der Platte anliegt, so dass die Oberfläche des Kolbenstopfens, die Unterfläche der Platte und die Dichtung zusammen kumulierend eine Kammer definieren;
Hinausschieben der besagten Vielzahl von elektrischen Kontaktstiften über eine Oberfläche des Kolbenstopfens, so dass die elektrischen Kontaktstifte die elektrischen Kontakte der Vorrichtungen in der Gruppe mechanisch kontaktieren;
Zurverfügungstellung eines Vakuums in der besagten Kammer, so dass ein Vakuum an die Unterfläche der Platte angewendet wird, um die Platte gegen den Kolbenstopfen zu saugen, um zu erreichen, dass elektrische Kontakte der Vorrichtungen in der Gruppe gegen die elektrischen Kontaktstifte des Kolbenstopfens drücken.

13. Verfahren gemäss Anspruch 11 oder 12, worin die Schritte des Hinausschiebens der besagten Vielzahl von elektrischen Kontaktstiften und der Anwendung eines Vakuums auf die Platte, um die Platte gegen das Kolbenstopfen zu saugen, gleichzeitig ausgeführt werden.

14. Verfahren gemäss irgendeinem der Ansprüche 5 bis 13, zudem mit den folgenden Schritten:
Durchführen von elektrischen Prüfungen gleichzeitig an allen Vorrichtungen in der Gruppe um gleichzeitig zu bestimmen, ob jede der Vorrichtungen in der Gruppe eine vordefinierte elektrische Eigenschaft aufweist, und
Durchführen von optischen Prüfungen auf nur diejenige Vorrichtungen in der Gruppe, für welche bestimmt wurde, dass sie die besagte vordefinierte Eigenschaft aufweisen, um zu bestimmen, ob die Vorrichtungen eine vordefinierte optische Eigenschaft aufweisen, und worin das besagte optische Testen der besagten Vorrichtungen nacheinander auf die besagten Vorrichtungen durchgeführt wird.

15. Verfahren gemäss irgendeinem der Ansprüche 5 bis 14, zudem mit den folgenden Schritten:
Zurverfügungstellung einer zweiten Platte, auf welcher eine andere Gruppe von zu testenden optischen Vorrichtungen zur Verfügung gestellt werden, wobei die zweite Platte eine unterschiedliche Form und/oder Grösse zu derjenigen der besagten Platte (55) aufweist;
aus der Vielzahl von Einlassadaptergliedern (170), Auswählen eines zweiten Einlassadapterglieds mit einer Öffnung, deren Form der Form der zweiten Platte entspricht und deren Dimensionen kleiner als die Dimensionen der zweite Platte sind;
Entfernen des Einlassadapterglieds (170), welches mit dem Abdeckglied zusammenarbeitet und Anordnen des zweiten Einlassadapterglieds, so dass es mit dem Abdeckglied zusammenarbeitet;
Verschieben der zweiten Platte, so dass die andere Gruppe von optischen Vorrichtungen in die Öffnung im zweiten Einlassadapterglied verschoben wird, so dass sie sich in Testposition befinden, und so dass die zweite Platte gegen das zweite Einlassadapterglied anliegt und die Öffnung optisch abgedichtet und somit die lichtintegrierende Kugel (5a) optisch abgedichtet wird.

## Revendications

1. Assemblage pour tester des appareils optiques, l'assemblage comprenant:
une sphère intégrante lumineuse (5a) ;
**caractérisé en ce que** l'assemblage comprend en outre
un élément masquant (160) définissant une fenêtre d'entrée (51) pour la sphère intégrante lumineuse (5a); et
une pluralité d'éléments d'entrés adaptables (170) dont chacun peut être arrangé sélectivement pour coopérer avec l'élément masquant (160) pour faire varier la quantité de lumière pouvant passer à travers la fenêtre d'entrée (51) dans la sphère intégrante lumineuse (5a),
et **en ce que** chaque élément de la pluralité d'éléments d'entrée adaptables (170) comprend une ouverture (171) ayant différentes formes et/ou dimensions.

2. Assemblage selon la revendication 1 comprenant en outre une pluralité de panneaux sur chacun desquels un réseau de test composé de dispositifs pour tester peut être fourni, **caractérisé en ce que** les dimensions de chaque panneau sont plus supérieures aux dimensions d'une ouverture aménagée dans un élément d'entrée adaptable correspondant, de façon à ce que chacun de la pluralité de panneaux puisse seller optiquement l'ouverture d'un élément d'entrée adaptable correspondant lorsque le panneau correspondant est déplacé en butée contre ledit élément d'entrée adaptable.

3. Assemblage selon l'une des revendications 1 ou 2, dans lequel l'élément masquant comprend en outre un canal et chaque élément d'entrée adaptable de la pluralité d'élément adaptable comprend un deuxième canal, **caractérisé en ce que** le deuxième canal de l'un quelconque des éléments d'entrée adaptable est en connexion fluidique avec le conduit de l'élément masquant lorsque l'élément d'entrée adaptable est sélectivement réversiblement fixé à l'élément masquant, et **en ce qu'**un générateur de vide est fourni pouvant être sélectivement en connexion fluidique avec le canal de l'élément masquant.

4. Assemblage selon l'une des revendications 1 à 3, **caractérisé en ce que** l'assemblage comprend en outre un support ayant une tête de piston sur la surface de laquelle un panneau ayant un réseau de détection peut être disposé,
**caractérisé en ce que** le support comprend en outre,
un joint qui s'étend au-dessus de la surface de la tête de piston ;
et une ou plusieurs bouches de succion aménagée dans la surface de la tête du piston à travers laquelle un vide peut exister pour aspirer un panneau vers la surface de la tête du piston, et **en ce que** le joint est arrangé pour entourer ladite bouche de succion ; et
des plots de contact électrique qui peuvent être sélectivement disposés sur la surface de la tête du piston pour assurer un contact électrique avec les dispositifs de test du réseau de test.

5. Méthode pour gérer un groupe des dispositifs optiques destinés à suivre un test optique, dans lequel le groupe comprend plus d'un dispositif optique, **caractérisé en ce que** la méthode comprend des étapes de,
déterminer les dimensions et/ou les formes d'un panneau (55) sur lequel un groupe de dispositifs optiques à tester est fourni ;
sélectionner parmi la pluralité d'éléments d'entrées adaptables (170), un élément d'entré adaptable ayant une ouverture (171) qui a des dimensions inférieures que les dimensions du panneau (55) et/ou ayant une forme correspondante à la forme du panneau (55) ;
arranger l'élément d'entrée adaptable (170) pour qu'il coopère avec l'élément masquant (160) de manière à modifier la quantité de lumière pouvant passer à travers la fenêtre d'entrée (51) dans la sphère intégrante lumineuse (5a);
déplacer le panneau (55) de façon à ce que le groupe de dispositifs optiques soit placé dans l'ouverture (171) des éléments d'entrées adaptables (171) pour qu'ils soient dans une position de test, et à ce que le panneau (55) soit en butée contre ledit élément d'entrée adaptable pour sceller optiquement la sphère intégrante lumineuse (5a).

6. Méthode selon la revendication 5 dans lequel, l'étape d'arranger l'élément d'entrée adaptable (170) pour qu'il coopère avec l'élément masquant (160) de manière à modifier la quantité de lumière pouvant passer à travers la fenêtre d'entrée (51) dans la sphère intégrante lumineuse (5a) comprend attacher de façon réversible l'élément d'entrée adaptable sélectionné à l'élément masquant, et dans lequel l'élément d'entrée adaptable recouvre la fenêtre d'entrée lorsque l'élément masquant est attaché de façon réversible.

7. Méthode selon l'une des revendications 5 ou 6, comprenant en outre une étape de sélection d'un panneau parmi une pluralité de panneau ayant des dimensions et/ou des formes différentes, et fournir un groupe de dispositifs optiques à tester sur le panneau sélectionné.

8. Méthode selon l'une quelconque des revendications 5 à 7, comprenant une étape de mise sous vide le panneau pour maintenir le panneau en butée contre l'élément d'entré adaptable, de façon à ce que le groupe de assemblages optique soit maintenu dans la position de test.

9. Méthode selon l'une quelconque des revendications 5 à 8, comprenant l'utilisation d'un support pour déplacer le panneau en butée contre l'élément d'entrée adaptable, dans lequel le support comprend une tête de piston sur la surface de laquelle un panneau ayant un réseau de détection peut être disposé, ladite étape d'utilisation d'un support pour déplacer le panneau en butée contre l'élément d'entrée adaptable comprend les étapes de
positionner un panneau dans lequel un groupe de dispositifs optiques à tester est fourni, sur la tête de piston ;
déplacer le support de façon à ce que la tête de piston et le panneau soit positionner sous l'élément d'entrée adaptable et centrés par rapport à l'ouverture de l'élément d'entrée adaptable ;
déplacer la tête de piston de manière à ce que le panneau soit en butée contre l'élément d'entrée adaptable et scelle optiquement l'ouverture de l'élément d'entrée adaptable.

10. Méthode selon l'une quelconque des revendications 5 à 9, comprenant les étapes de
exercer un vide sur le panneau qui aspire le panneau vers la tête de piston ; et
exercer simultanément un vide sur le panneau pour maintenir le panneau en butée contre l'élément d'entrée adaptable ;
et ensuite arrêter le vide qui aspire le panneau contre la tête de piston de manière à ce que le vide qui maintient le panneau en butée contre l'élément d'entrée adaptable s'exerce exclusivement sur le panneau.

11. Méthode selon l'une quelconque des revendications 5 à 10, comprenant les étapes de
exercer un vide sur le panneau pour maintenir le panneau en butée contre l'élément d'entrée adaptable ;
étendre ladite pluralité de plots de contact électrique sur la surface tête de piston, de manière à ce que les plots de contact électrique soient en contact mécanique avec les pièces de contacts électriques des dispositifs du groupe, le groupe comprenant plus d'un dispositif;
exercer un vide sur le panneau pour aspirer le panneau vers la tête de piston.

12. Méthode selon l'une des revendications 1 à 11, comprenant
Fournir un support ayant une tête de piston sur la surface de laquelle un panneau ayant un réseau de détection peut être disposé, le support comprend en outre un joint qui s'étend au-dessus de la surface de la tête de piston ; et une ou plusieurs bouches de succion aménagée dans la surface de la tête du piston à travers laquelle un vide peut exister pour aspirer un panneau vers la surface de la tête du piston, et en ce que le joint est arrangé pour entourer ladite bouche de succion ; et des plots de contact électrique qui peuvent être sélectivement disposés sur la surface de la tête du piston pour assurer un contact électrique avec les dispositifs du réseau de détection ;
dans laquelle la méthode comprend,
exercer un vide sur le panneau pou maintenir le panneau en butée contre l'élément d'entrée adaptable ;
déplacer la tête du piston du support de manière à ce que le joint soit en butée sur une surface inférieure du panneau, de façon à ce que la surface de la tête du piston, la surface inférieure et le joint définissent ensemble une chambre ;
étendre ladite pluralité de plots de contact électrique sur la surface tête de piston, de manière à ce que les plots de contact électrique soient en contact mécanique avec les pièces de contacts électriques des dispositifs du groupe;
faire le vide dans ladite chambre de manière à ce qu'un vide soit exercé sur la surface inférieure du panneau pour aspirer le panneau vers la tête du piston pour induire un contact électrique des dispositifs du groupe pour repousser les plots de contact électrique de la tête de piston.

13. Méthode selon l'une quelconque des revendications 11 ou 12, dans laquelle les étapes d'extension de ladite pluralité de plots de contact électrique et d'application d'un vide sur le panneau pour aspirer le panneau vers la tête du piston sont exécutées simultanément.

14. Méthode selon l'une quelconque des revendications 5 à 13 comprenant en outre les étapes de,
Réaliser un test électrique de tous les dispositifs du groupe simultanément pour déterminer si chacun des dispositifs présente une propriété électrique prédéfinie, et
Réaliser un test optique uniquement sur les dispositifs du groupe qui présente ladite propriété électrique prédéfinie, pour déterminer si les dispositifs présentent une propriété optique prédéterminée, ledit test optique desdits dispositifs étant réalisé successivement sur lesdits dispositifs.

15. Méthode selon l'une quelconque des revendications 5 à 14 comprenant en outre les étapes de,
Fournir un second panneau dans lequel un autre groupe de dispositifs optiques à tester est disposé, le second panneau ayant une forme et/ou dimension différente dudit panneau (55) ;
Sélectionner parmi la pluralité d'éléments d'entrées adaptables (170), un second élément d'entrée adaptable ayant une ouverture qui a une forme correspondant à la forme du second panneau et des dimensions qui sont inférieures aux dimensions du second panneau;
Retirer l'élément d'entrée adaptable qui coopère avec l'élément masquant, et arranger le deuxième élément d'entrée adaptable pour qu'il coopère avec l'élément masquant;
Déplacer le deuxième panneau pour que le deuxième groupe de dispositifs optiques soit déplacé dans l'ouverture du second élément d'entrée adaptable de façon à ce qu'ils soient dans une position de teste, et que le deuxième panneau soit en butée contre le second élément d'entrée adaptable et scelle optiquement l'ouverture permettant de seller optiquement sphère intégrante lumineuse.
